# EUROPEAN PATENT SPECIFICATION

(11) **EP 3 037 901 B1**
(45) Date of publication and mention of the grant of the patent: **12.12.2018**
(21) Application number: 15201992.3
(22) Date of filing: 22.12.2015
(51) Int. Cl.: G05B 19/418, G05B 17/02

(54) **CLOUD-BASED EMULATION AND MODELING FOR AUTOMATION SYSTEMS**
CLOUD-BASIERTE EMULATION UND MODELLIERUNG FÜR AUTOMATISIERUNGSSYSTEME
ÉMULATION EN NUAGE ET MODÉLISATION DE SYSTÈMES D'AUTOMATISATION

(30) Priority: 22.12.2014 US 201414580191
(43) Date of publication of application: 29.06.2016
(73) Proprietor: Rockwell Automation Technologies, Inc., Mayfield Heights, OH 44124 (US)
(72) Inventor: MATURANA, Francisco P., Lyndhurst, OH 44124 (US); MANSOURI, Haithem, Beachwood, OH 44122 (US); KRIZ, Jaroslav, 40001 Usti nad Labem, Klise (CZ); ASENJO, Juan L., Timberlake, OH 44095 (US)
(74) Representative: Grünecker Patent- und Rechtsanwälte PartG mbB

(56) References cited:
- EP-A1- 1 857 896
- EP-A1- 2 801 935
- US-A1- 2014 047 107

## Description

### BACKGROUND

The subject matter disclosed herein relates generally to industrial analytics, and, more particularly, to a multi-tier industrial cyber analytics system implemented on a cloud-based storage and processing infrastructure.

EP 1 857 896 A1 discloses an emulator of a controller of an industrial plant, in particular of an electric energy generating plant. An emulation unit, a structural configuration unit, a functional configuration unit, an acquisition unit, a driving unit and communication ports that reside in a single electronic computer are disclosed. Structural configuration unit allows to define a virtual copy of the physical structure or architecture of a controller, while functional configuration unit reproduces the functional features. For this purpose, functional configuration unit is provided with a communication port, which must be connected to controller to fetch the current CFDA configuration data and transfer them to emulation unit.

US 2014/047107 A1 discloses deployment of cloud data storage farms for storing alarm, historical, and live automation data using an agent-based communication channel. A cloud-based infrastructure is disclosed for gathering, transmitting, and remotely storing control and automation data and relating information.

EP 2 801 935 A1 discloses migration of industrial data to a cloud platform for collective analysis and device management. Systems and methods are provided for migrating a customer's industrial data from all stages of manufacturing, as well as throughout the supply chain, to a cloud platform for collective big data analysis.

### BRIEF DESCRIPTION

It is therefore the object of the present invention to provide an improved system for performing industrial analytics, a corresponding method, and a corresponding computer-readable medium.

This object is solved by the subject matter of the independent claims.

Preferred embodiments are defined by the dependent claims.

The following presents a simplified summary in order to provide a basic understanding of some aspects described herein. This summary is not an extensive overview nor is intended to identify key/critical elements or to delineate the scope of the various aspects described herein. Its sole purpose is to present some concepts in a simplified form as a prelude to the more detailed description that is presented later.

In one or more embodiments, a system for performing industrial analytics is provided, comprising an emulation component configured to execute a virtualized industrial controller on a cloud platform; a simulation component configured to execute a simulation of an industrial system on the cloud platform; an emulation data exchange component configured to execute an emulation data exchange interface (EDEI) that communicatively connects the virtualized controller and the simulation; and an analytics component configured to generate output data directed to a client device via the cloud platform based on analysis of a simulation session performed by the simulation and the virtualized controller.

Also, one or more embodiments provide a method for analyzing performance of an industrial system, comprising executing, by a system comprising at least one processor, a virtualized controller on a cloud platform; executing, by the system, a simulation of an industrial system on the cloud platform; executing, by the system, an emulation data exchange interface (EDEI) that facilitates exchange of simulation data between the virtualized controller and the simulation; performing, by the system, analytics on a simulation session performed by the virtualized controller and the simulation; sending, by the system, output data to a client device via the cloud platform based on the analytics.

Also, according to one or more embodiments, a non-transitory computer-readable medium is provided having stored thereon instructions that, in response to execution, cause a system to perform operations, the operations, comprising executing a virtualized controller on a cloud platform; executing a simulation of an industrial system on the cloud platform; executing an emulation data exchange interface (EDEI) that facilitates exchange of simulation data between the virtualized controller and the simulation; performing analytics on a simulation session performed by the virtualized controller and the simulation; and sending, by the system, output data to a client device via the cloud platform based on the analytics.

To the accomplishment of the foregoing and related ends, certain illustrative aspects are described herein in connection with the following description and the annexed drawings. These aspects are indicative of various ways which can be practiced, all of which are intended to be covered herein. Other advantages and novel features may become apparent from the following detailed description when considered in conjunction with the drawings.

### BRIEF DESCRIPTION OF THE DRAWINGS

FIG. 1 is a generalized block diagram illustrating interactions between a control program and a simulation of a process to be controlled by the program.
FIG. 2 is a diagram illustrating configuration of plant-level and cloud-level modeling and analytics systems.
FIG. 3 is a diagram of a high-level overview of an industrial enterprise that leverages cloud-based services.
FIG. 4 is a block diagram of an example cloud-based industrial emulation and analytics system.
FIG. 5 is an overview of a system that leverages an agent-based cloud infrastructure to provide data collection and processing services to customer manufacturing sites.
FIG. 6 is a block diagram illustrating functionality of a cloud agent device.
FIG. 7 is a diagram of an example compressed data packet.
FIG. 8 is a diagram of a general architecture for a multi-tier cyber analytics system that executes on a cloud platform and interfaces hardware control systems and simulations at multiple locations with cloud-level analytics services.
FIG. 9 is a diagram illustrating runtime of an EDEI service of the cloud-based cyber analytics system.
FIG. 10 is a diagram illustrating delivery of predictive data by the cloud-based cyber analytics system.
FIG. 11 is a flowchart of an example methodology for implementing enterprise-level supervisory monitoring of one or more industrial systems using cloud services.
FIG. 12 is a flowchart of an example methodology for simulating an industrial system on a cloud platform.
FIG. 13 is a flowchart of an example methodology for interfacing distributed on-premise simulations with a virtualized controller executing on a cloud platform.
FIG. 14 is an example computing environment.
FIG. 15 is an example networking environment.

### DETAILED DESCRIPTION

The subject disclosure is now described with reference to the drawings, wherein like reference numerals are used to refer to like elements throughout. In the following description, for purposes of explanation, numerous specific details are set forth in order to provide a thorough understanding thereof. It may be evident, however, that the subject disclosure can be practiced without these specific details. In other instances, well-known structures and devices are shown in block diagram form in order to facilitate a description thereof.

As used in this application, the terms "component," "system," "platform," "layer," "controller," "terminal," "station," "node," "interface" are intended to refer to a computer-related entity or an entity related to, or that is part of, an operational apparatus with one or more specific functionalities, wherein such entities can be either hardware, a combination of hardware and software, software, or software in execution. For example, a component can be, but is not limited to being, a process running on a processor, a processor, a hard disk drive, multiple storage drives (of optical or magnetic storage medium) including affixed (e.g., screwed or bolted) or removable affixed solid-state storage drives; an object; an executable; a thread of execution; a computer-executable program, and/or a computer. By way of illustration, both an application running on a server and the server can be a component. One or more components can reside within a process and/or thread of execution, and a component can be localized on one computer and/or distributed between two or more computers. Also, components as described herein can execute from various computer readable storage media having various data structures stored thereon. The components may communicate via local and/or remote processes such as in accordance with a signal having one or more data packets (e.g., data from one component interacting with another component in a local system, distributed system, and/or across a network such as the Internet with other systems via the signal). As another example, a component can be an apparatus with specific functionality provided by mechanical parts operated by electric or electronic circuitry which is operated by a software or a firmware application executed by a processor, wherein the processor can be internal or external to the apparatus and executes at least a part of the software or firmware application. As yet another example, a component can be an apparatus that provides specific functionality through electronic components without mechanical parts, the electronic components can include a processor therein to execute software or firmware that provides at least in part the functionality of the electronic components. As further yet another example, interface(s) can include input/output (I/O) components as well as associated processor, application, or Application Programming Interface (API) components. While the foregoing examples are directed to aspects of a component, the exemplified aspects or features also apply to a system, platform, interface, layer, controller, terminal, and the like.

As used herein, the terms "to infer" and "inference" refer generally to the process of reasoning about or inferring states of the system, environment, and/or user from a set of observations as captured via events and/or data. Inference can be employed to identify a specific context or action, or can generate a probability distribution over states, for example. The inference can be probabilistic-that is, the computation of a probability distribution over states of interest based on a consideration of data and events. Inference can also refer to techniques employed for composing higher-level events from a set of events and/or data. Such inference results in the construction of new events or actions from a set of observed events and/or stored event data, whether or not the events are correlated in close temporal proximity, and whether the events and data come from one or several event and data sources.

In addition, the term "or" is intended to mean an inclusive "or" rather than an exclusive "or." That is, unless specified otherwise, or clear from the context, the phrase "X employs A or B" is intended to mean any of the natural inclusive permutations. That is, the phrase "X employs A or B" is satisfied by any of the following instances: X employs A; X employs B; or X employs both A and B. In addition, the articles "a" and "an" as used in this application and the appended claims should generally be construed to mean "one or more" unless specified otherwise or clear from the context to be directed to a singular form.

Furthermore, the term "set" as employed herein excludes the empty set; e.g., the set with no elements therein. Thus, a "set" in the subject disclosure includes one or more elements or entities. As an illustration, a set of controllers includes one or more controllers; a set of data resources includes one or more data resources; etc. Likewise, the term "group" as utilized herein refers to a collection of one or more entities; e.g., a group of nodes refers to one or more nodes.

Various aspects or features will be presented in terms of systems that may include a number of devices, components, modules, and the like. It is to be understood and appreciated that the various systems may include additional devices, components, modules, etc. and/or may not include all of the devices, components, modules etc. discussed in connection with the figures. A combination of these approaches also can be used.

Industrial controllers and their associated I/O devices are central to the operation of modern automation systems. These controllers interact with field devices on the plant floor to control automated processes relating to such objectives as product manufacture, material handling, batch processing, supervisory control, and other such applications. Industrial controllers store and execute user-defined control programs to effect decision-making in connection with the controlled process. Such programs can include, but are not limited to, ladder logic, sequential function charts, function block diagrams, structured text, or other such programming structures.

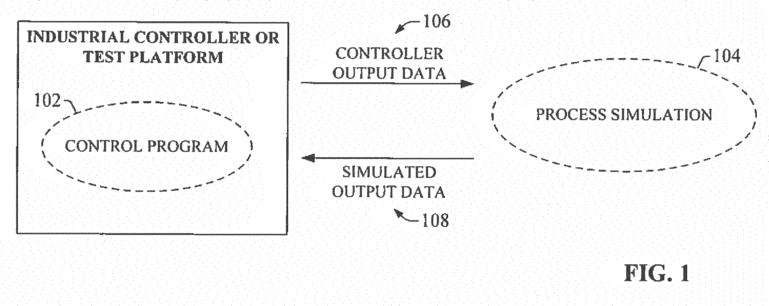

Many system designers use simulations of a plant or industrial system to validate an industrial control program prior to deployment, to predict the effects of a change to the industrial process or control program (e.g., to estimate the change in product yield, energy or material consumption, costs, etc.). Such simulations emulate various aspects of a physical system to be regulated by the control program. The simulations interface with the control program under test to exchange I/O data in order to simulate real-time control. FIG. 1 is a generalized block diagram illustrating interactions between a control program and a simulation of a process to be controlled by the program. Control program 102 - which may run on an industrial controller or on a test platform prior to deployment in an industrial controller - can comprise any conceivable type of code used to process input signals read into a controller and to control output signals from the controller, including but not limited to ladder logic, sequential function charts, function block diagrams, or structured text. Control program 102 is designed to regulate a plant or an automation system therein. Process simulation 104 is a dynamic model representing the plant or automation system to be regulated by control program 102. Process simulation 104 mathematically models the system to be regulated by generating digital and analog I/O values representing, for example, sensor outputs, metering outputs, or other plant data analogous to the data expected to be generated by the physical system being modeled. This simulated output data 108 is provided to the control program, which receives this data as one or more virtual physical inputs. Control program 102 processes these inputs according to user-defined algorithms, and generates digital and/or analog controller output data 106 based on the processing. This output data 106 represents the physical outputs that would be generated by a controller executing control program 102 and transmitted to the hardwired field devices comprising the automation system (*e.g.,* PID loop control outputs, solenoid energizing outputs, motor control outputs, *etc*.). The controller output data 106 is provided to the appropriate input points of the process simulation 104, which updates the simulated output data 108 accordingly. This simulation technique can be used to test and debug control programs without putting field equipment and machinery at risk, to simulate modifications to plant or machine operations and estimation how such modifications affect certain performance or financial metrics, or to perform other analytics.

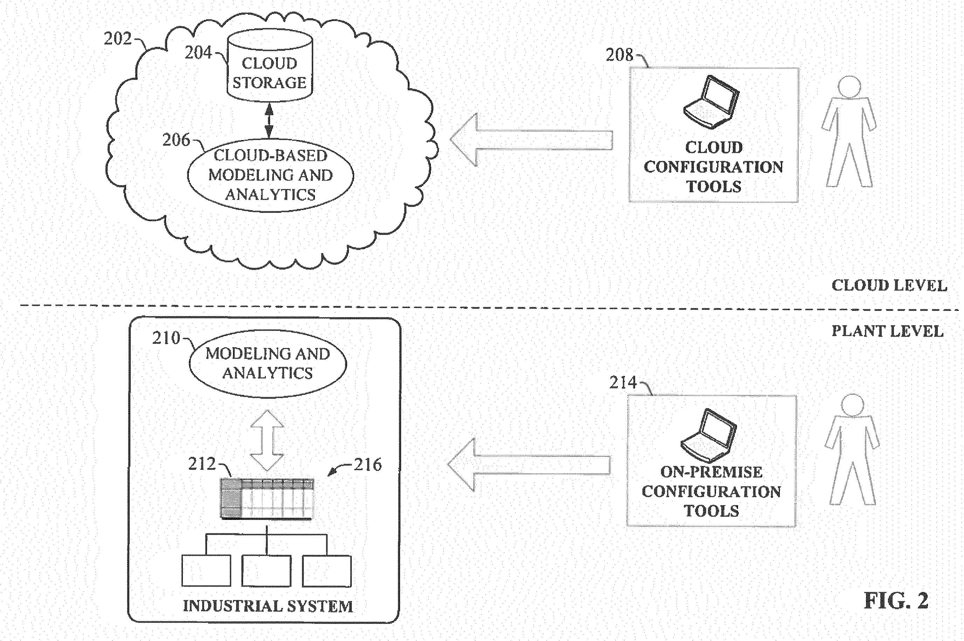

Enterprise-level modeling and simulation of a distributed industrial enterprise comprising multiple inter-related facilities could be achieved by modeling and simulating the systems in a cloud platform. FIG. 2 is a diagram illustrating configuration of plant-level and cloud-level modeling and analytics systems. In this example, a modeling and analytics system 210 on the plant level interacts with an on-premise industrial controller 212 - either before deployment of the controller or during control of an industrial system 216 - to perform system validation, modeling, analytics, or other functions. Modeling and analytics system 210 may execute, for example, on a workstation or simulation module residing on the plant floor. Similarly, a cloud-based modeling and analytics system 206 executing on a cloud platform may leverage data maintained in cloud storage 204 - e.g., historical and/or near real-time data collected from one or more industrial devices - to perform similar analytical functions on the cloud. These cloud and on-premise analytic systems are decoupled, requiring separate configuration and software development tools to achieve enterprise level modeling of an industrial system. For example, modeling and analytics system 210 and industrial controller 212 may be configured using on-premise configuration tools 214, which may comprise industrial control program development software (e.g., a ladder logic development platform) and simulation building software. Cloud-based modeling and analytics system 206, which executes on a different type of platform in the cloud, must be configured using a different set of cloud configuration tools 208 not familiar to an industrial control system designer. Often, cloud-based analytics systems must be configured by data scientists with expertise in big data analytics.

Cloud-based industrial analytics systems would have considerable value in the areas of enterprise-level virtual design engineering, modeling, validation, monitoring, and analytics. Such systems could effectively leverage the high performance capabilities afforded by the cloud platform in an integrated framework.

To these and other ends, one or more embodiments of the present disclosure provide a multi-tier cyber analytics system including an emulation runtime engine that can execute a virtualized controller on a cloud platform. The runtime engine can serve as a core analytics component by providing a control-level analytics engine with application programming interfaces (APIs) that enable seamless interaction of distributed simulations, cloud level services, and hardware industrial controllers. A cloud-based framework integrates soft control, hard control, and simulation with cloud-level services, and includes components that facilitate near real-time data streaming from the plant floor to the cloud platform to yield an industrial Internet of Things (IoT).

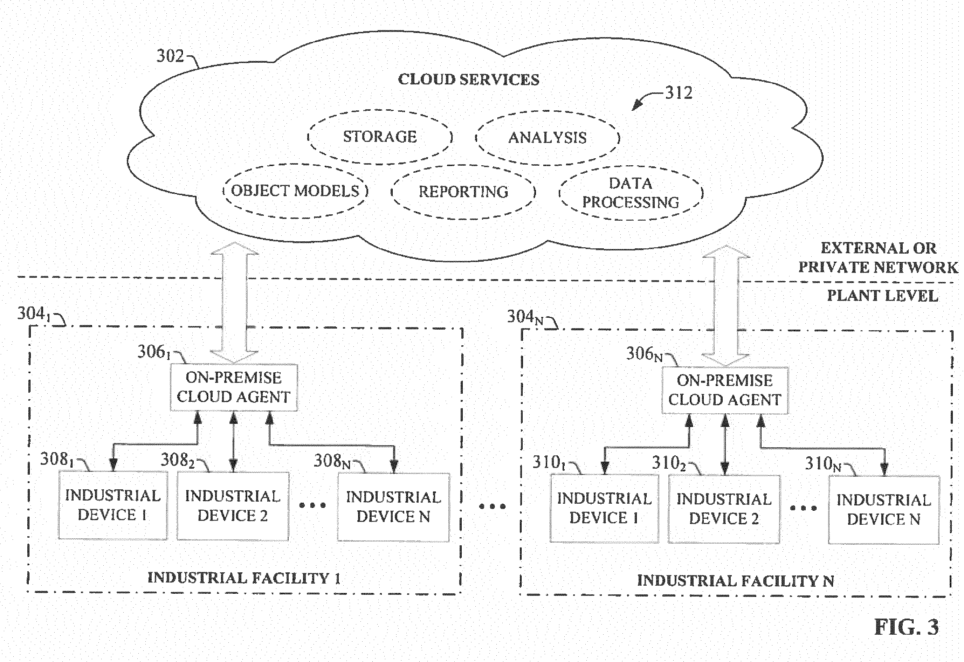

FIG. 3 illustrates a high-level overview of an industrial enterprise that leverages cloud-based services. The enterprise comprises one or more industrial facilities 304, each having a number of industrial devices 308 and 310 in use. The industrial devices 308 and 310 can make up one or more automation systems operating within the respective facilities 304. Exemplary automation systems can include, but are not limited to, batch control systems (e.g., mixing systems), continuous control systems (e.g., PID control systems), or discrete control systems. Industrial devices 308 and 310 can include such devices as industrial controllers (e.g., programmable logic controllers or other types of programmable automation controllers); field devices such as sensors and meters; motor drives; operator interfaces (e.g., human-machine interfaces, industrial monitors, graphic terminals, message displays, etc.); industrial robots, barcode markers and readers; vision system devices (e.g., vision cameras); smart welders; or other such industrial devices.

Exemplary automation systems can include one or more industrial controllers that facilitate monitoring and control of their respective processes. The controllers exchange data with the field devices using native hardwired I/O or via a plant network such as Ethernet/IP, Data Highway Plus, ControlNet, Devicenet, or the like. A given controller typically receives any combination of digital or analog signals from the field devices indicating a current state of the devices and their associated processes (e.g., temperature, position, part presence or absence, fluid level, etc..), and executes a user-defined control program that performs automated decision-making for the controlled processes based on the received signals. The controller then outputs appropriate digital and/or analog control signaling to the field devices in accordance with the decisions made by the control program. These outputs can include device actuation signals, temperature or position control signals, operational commands to a machining or material handling robot, mixer control signals, motion control signals, and the like. The control program can comprise any suitable type of code used to process input signals read into the controller and to control output signals generated by the controller, including but not limited to ladder logic, sequential function charts, function block diagrams, structured text, or other such platforms.

Although the example overview illustrated in FIG. 3 depicts the industrial devices 308 and 310 as residing in fixed-location industrial facilities 304, the industrial devices 308 and 310 may also be part of a mobile control application, such as a system contained in a truck or other service vehicle.

According to one or more embodiments, on-premise cloud agents 306 can collect data from industrial devices 308 and 310 - or from other data sources, including but not limited to data historians, business-level systems, etc. - and send this data to cloud platform 302 for processing and storage. Cloud platform 302 can be any infrastructure that allows cloud services 312 to be accessed and utilized by cloud-capable devices. Cloud platform 302 can be a public cloud accessible via the Internet by devices having Internet connectivity and appropriate authorizations to utilize the services 312. In some scenarios, cloud platform 302 can be provided by a cloud provider as a platform-as-a-service (PaaS), and the services 312 (such as the manifest system described herein) can reside and execute on the cloud platform 302 as a cloud-based service. In some such configurations, access to the cloud platform 302 and the services 312 can be provided to customers as a subscription service by an owner of the services 312. Alternatively, cloud platform 302 can be a private or semi-private cloud operated internally by the enterprise, or a shared or corporate cloud environment. An exemplary private cloud can comprise a set of servers hosting the cloud services 312 and residing on a corporate network protected by a firewall.

Cloud services 312 can include, but are not limited to, data storage, data analysis, control applications (e.g., applications that can generate and deliver control instructions to industrial devices 308 and 310 based on analysis of real-time system data or other factors), visualization applications such as the cloud-based operator interface system described herein, reporting applications, Enterprise Resource Planning (ERP) applications, notification services, or other such applications. Cloud platform 302 may also include one or more object models to facilitate data ingestion and processing in the cloud. If cloud platform 302 is a web-based cloud, cloud agents 306 at the respective industrial facilities 304 may interact with cloud services 312 directly or via the Internet. In an exemplary configuration, the industrial devices 308 and 310 connect to the on-premise cloud agents 306 through a physical or wireless local area network or radio link. In another exemplary configuration, the industrial devices 308 and 310 may access the cloud platform 302 directly using integrated cloud agents.

Ingestion of industrial device data in the cloud platform 302 through the use of cloud agents 306 can offer a number of advantages particular to industrial automation. For one, cloud-based storage offered by the cloud platform 302 can be easily scaled to accommodate the large quantities of data generated daily by an industrial enterprise. Moreover, multiple industrial facilities at different geographical locations can migrate their respective automation data to the cloud for aggregation, collation, collective analysis, visualization, and enterprise-level reporting without the need to establish a private network between the facilities. Cloud agents 306 can be configured to automatically detect and communicate with the cloud platform 302 upon installation at any facility, simplifying integration with existing cloud-based data storage, analysis, or reporting applications used by the enterprise. In another example application, cloud-based diagnostic applications can monitor the health of respective automation systems or their associated industrial devices across an entire plant, or across multiple industrial facilities that make up an enterprise. Cloud-based lot control applications can be used to track a unit of product through its stages of production and collect production data for each unit as it passes through each stage (e.g., barcode identifier, production statistics for each stage of production, quality test data, abnormal flags, etc.). Moreover, cloud based control applications can perform remote decision-making for a controlled industrial system based on data collected in the cloud from the industrial system, and issue control commands to the system via the cloud agent. These industrial cloud-computing applications are only intended to be exemplary, and the systems and methods described herein are not limited to these particular applications. The cloud platform 302 can allow software vendors to provide software as a service, removing the burden of software maintenance, upgrading, and backup from their customers.

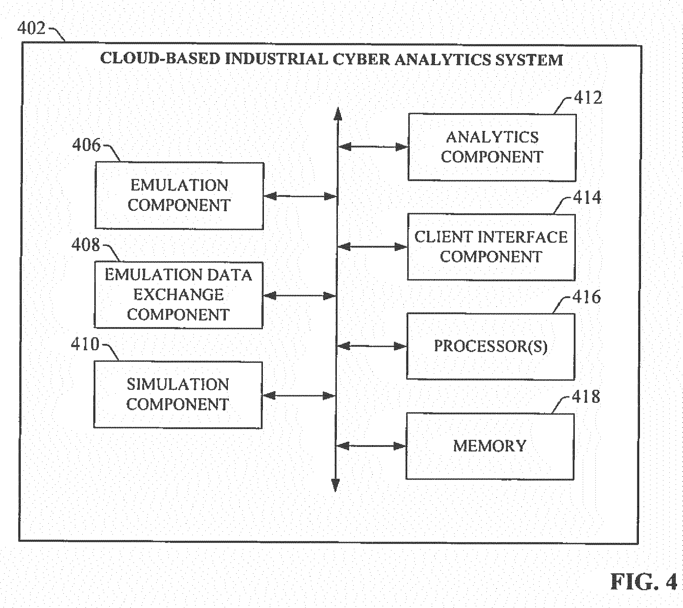

FIG. 4 is a block diagram of an example cloud-based industrial cyber analytics system 402 according to one or more embodiments of this disclosure. Aspects of the systems, apparatuses, or processes explained in this disclosure can constitute machine-executable components embodied within machine(s), e.g., embodied in one or more computer-readable mediums (or media) associated with one or more machines. Such components, when executed by one or more machines, e.g., computer(s), computing device(s), automation device(s), virtual machine(s), etc., can cause the machine(s) to perform the operations described.

Cloud-based industrial cyber analytics system 402 can include an emulation component 406, an emulation data exchange component 408, a simulation component 410, an analytics component 412, a client interface component 414, one or more processors 416, and memory 418. In various embodiments, one or more of the emulation component 406, emulation data exchange component 408, simulation component 410, analytics component 412, client interface component 414, the one or more processors 416, and memory 418 can be electrically and/or communicatively coupled to one another to perform one or more of the functions of the emulation and analytics system 402. In some embodiments, components 406, 408, 410, 412, and 414 can comprise software instructions stored on memory 418 and executed by processor(s) 416. Cyber analytics system 402 may also interact with other hardware and/or software components not depicted in FIG. 4. For example, processor(s) 416 may interact with one or more external user interface devices, such as a keyboard, a mouse, a display monitor, a touchscreen, or other such interface devices.

Emulation component 406 can be configured to execute a virtualized industrial controller on a cloud platform. For example, emulation component 406 can comprise a soft controller engine that can be programmed using standard industrial control programming software (e.g., a same programming platform used to program a hardware industrial controller), and can include an API layer that allows the controller engine to interface with cloud data storage, simulations, and on-premise hardware devices. Emulation data exchange component 408 can be configured to provide connectivity between the emulation component's API, cloud-based simulations, distributed on-premise simulations, and cloud services.

Simulation component 410 can be configured to execute cloud-based simulations that interact with the virtualized controller executed by emulation component 406. Analytics component 412 can be configured to analyze results of the cloud-based simulations for the purposes of system validation, near real-time monitoring, predictive analysis, product life cycle management, or other such applications.

Client interface component 414 can be configured to exchange data with one or more client devices via an Internet connection. For example, client interface component 414 can deliver dashboard interfaces to authorized client devices that allow a user to configure aspects of a cloud-based simulation or to view analysis results or live data associated with the emulated system. In some embodiments, client interface component 414 can also generate and deliver notifications to specified client devices in response to detected conditions.

The one or more processors 416 can perform one or more of the functions described herein with reference to the systems and/or methods disclosed. Memory 418 can be a computer-readable storage medium storing computer-executable instructions and/or information for performing the functions described herein with reference to the systems and/or methods disclosed.

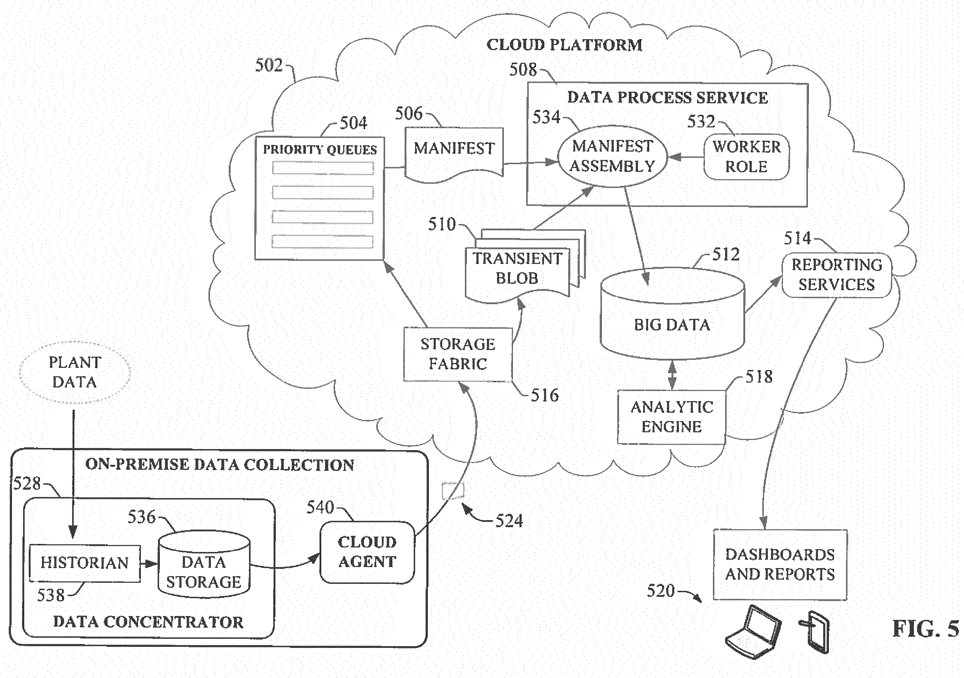

The cloud-based analytics system described herein leverages historical and/or real-time data collected into cloud storage from on-premise industrial devices. Any suitable technique for moving plant floor data to cloud storage for cloud-level analysis are within the scope of one or more embodiments of this disclosure. In some embodiments, a cloud agent architecture can be used to push industrial system data to the cloud platform. According to this cloud agent architecture, the industrial system data is collected by on-premise cloud agent devices, packaged into data packets, and pushed to the cloud platform for remote viewing. FIG. 5 is an overview of a system that leverages an agent-based cloud infrastructure to provide data collection and processing services to customer manufacturing sites. This system can provide remote collection and monitoring services in connection with alarm and event notification for critical industrial assets, historical data collection, remote system access, system optimization, remote closed-loop control, and other such applications.

In the example illustrated in FIG. 5, a data concentrator 528 collects plant data from one or more industrial assets (e.g., data generated by one or more industrial controllers, such as industrial devices 308 or 310) at a plant facility. These industrial assets can include industrial controllers that monitor and control industrial I/O devices, data servers and historians, motor drives, remote I/O interfaces that remotely interface groups of I/O devices to one or more of the industrial controllers, boilers or other industrial machines, or other such assets. For example, data concentrator 528 can monitor one or more controller tags defined in a tag archive and store data in local data storage 536 (e.g., a local structured query language, or SQL, server) associated with a historian 538. The collected data can include historical data (e.g., alarm history, status history, trend data, etc.), live data values read from the industrial assets, alarm data generated by the industrial assets, or other types of data.

An on-premise cloud agent 540 is configured to collect the live or historical data from the industrial assets, either directly or by accessing data storage 536 associated with data concentrator 528. Cloud agent 540 can execute on any suitable hardware platform (e.g., a server, a LINUX box, etc.), and acts as a generic gateway that collects data items from the various industrial assets on the plant network and packages the collected data according to a generic, uniform data packaging schema used to move the on-premise data to a cloud platform 502. Cloud agent 540 provides a software mechanism to dynamically link on-premise-to-cloud gateways. Cloud agent 540 provides an expandable data type schema that allows new data types to be added without the need to redeploy the monitoring system to the cloud.

During data collection, the cloud agent 540 can intelligently sort and organize the data based on defined criteria, including but not limited to time of occurrence and/or user-defined priorities. Cloud agent 540 can be, for example, a service (e.g., a Windows service) that periodically collects and transmits serialized and compressed data into the cloud domain using standard web services over HTTPS/SSL.

FIG. 5 depicts data concentrator 528 as the data source for cloud agent 540. This configuration can be useful if there are a large number of data points to monitor, since the data concentrator can 528 can link multiple industrial devices or other data sources to a single cloud agent 540. However, some embodiments of cloud agent 540 can collect data directly from the industrial assets themselves; e.g., through a common industrial protocol link, or through middleware applications such as OPC clients.

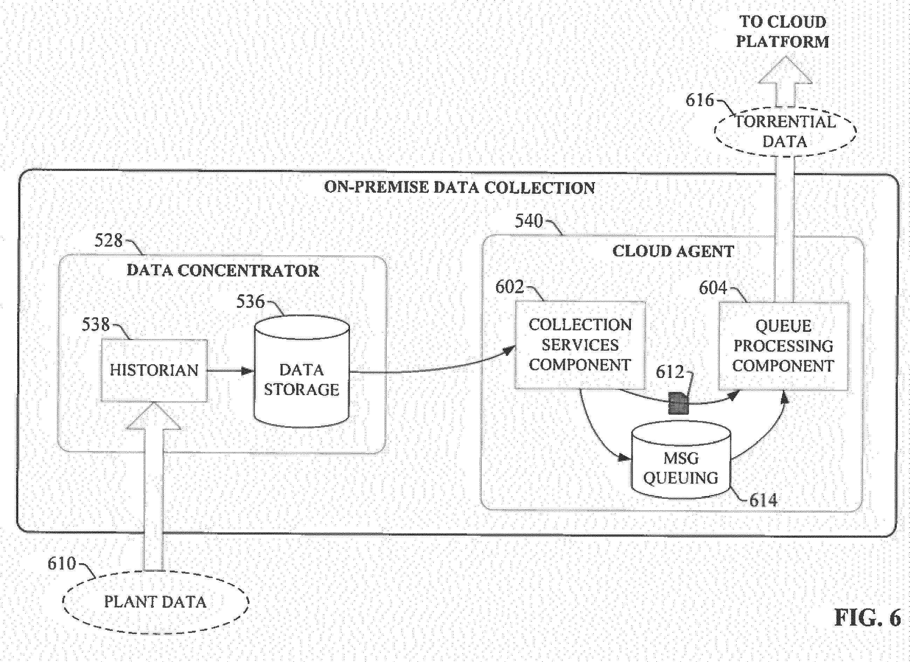

Cloud agent functionality is illustrated in more detail with reference to FIG. 6. On-premise data collection is enabled by a collection of services that function as a virtual support engineer for processing data. Data concentrator 528 and cloud agent 540 respectively implement two main functions associated with data collection - data concentration using a historian 538 and associated data storage 536 (e.g., an SQL server), and cloud data enablement using cloud agent services executed by cloud agent 540. As noted above, plant data 610 is collected by data concentrator 528 at the plant facility. In an example scenario, plant data 610 may comprise stamping press time series sensor data, made up of thousands of data points updated at a rate of less than a second.

Collection services component 602 of cloud agent 540 implements collection services that collect device data, either from data concentrator's associated data storage (e.g., via an SQL query) or directly from the devices themselves via a common industrial protocol (CIP) link or other suitable communication protocol. For example, to obtain data from data concentrator 528, collection services component 602 may periodically run a data extraction query (e.g., an SQL query) to extract data from data storage 536 associated with data concentrator 528. Collection services component 602 can then compress the data and store the data in a compressed data file 612. Queue processing services executed by queue processing component 604 can then read the compressed data file 612 and reference a message queuing database 614, which maintains and manage customer-specific data collection configuration information, as well as information relating to the customer's subscription to the cloud platform and associated cloud services. Based on configuration information in the message queuing database 614, queue processing component 604 packages the compressed data file 612 into a data packet and pushes the data packet to the cloud platform. In some embodiments, the cloud agent 540 can support injecting data packets as torrential data 616.

Message queuing database 614 can include site-specific information identifying the data items to be collected (e.g., data tag identifiers), user-defined processing priorities for the data tags, firewall settings that allow cloud agent 540 to communicate with the cloud platform through a plant firewall, and other such configuration information. Configuration information in message queuing database 614 instructs cloud agent 540 how to communicate with the identified data tags and with the remote data collection services on the cloud platform.

In addition to collection and migration of data, one or more embodiments of cloud agent 540 can also perform local analytics on the data prior to moving the data to the cloud platform. This can comprise substantially any type of pre-processing or data refinement that may facilitate efficient transfer of the data to the cloud, prepare the data for enhanced analysis in the cloud, reduce the amount of cloud storage required to store the data, or other such benefits. For example, cloud agent 540 may be configured to compress the collected data using any suitable data compression algorithm prior to migrating the data to the cloud platform. This can include detection and deletion of redundant data bits, truncation of precision bits, or other suitable compression operations. In another example, cloud agent 540 may be configured to aggregate data by combining related data from multiple sources. For example, data from multiple sensors measuring related aspects of an automation system can be identified and aggregated into a single cloud upload packet by cloud agent 540. Cloud agent 540 may also encrypt sensitive data prior to upload to the cloud. In yet another example, cloud agent 540 may filter the data according to any specified filtering criterion (e.g., filtering criteria defined in a filtering profile stored on the cloud agent). For example, defined filtering criteria may specify that pressure values exceeding a defined setpoint are to be filtered out prior to uploading the pressure values to the cloud.

In some embodiments, cloud agent 540 may also transform a specified subset of the industrial data from a first format to a second format in accordance with a requirement of a cloud-based analysis application. For example, a cloud-based reporting application may require measured values in ASCII format. Accordingly, cloud agent 540 can convert a selected subset of the gathered data from floating point format to ASCII prior to pushing the data to the cloud platform for storage and processing. Converting the raw data at the industrial device before uploading to the cloud, rather than requiring this transformation to be performed on the cloud, can reduce the amount of processing load on the cloud side.

Cloud agent 540 may also associate metadata with selected subsets of the data prior to migration to the cloud, thereby contextualizing the data within the industrial environment. For example, cloud agent 540 can tag selected subsets of the data with a time indicator specifying a time at which the data was generated, a quality indicator, a production area indicator specifying a production area within the industrial enterprise from which the data was collected, a machine or process state indicator specifying a state of a machine or process at the time the data was generated, a personnel identifier specifying an employee on duty at the time the data was generated, or other such contextual metadata. In this way, cloud agent 540 can perform layered processing of the collected data to generate meta-level knowledge that can subsequently be leveraged by cloud-based analysis tools to facilitate enhanced analysis of the data in view of a larger plant context.

To ensure secure outbound traffic to the cloud, one or more embodiments of cloud agent 540 can support HTTPS/SSL, certificate authority enabled transmission, and/or unique identity using MAC addresses. Cloud agent 540 can also support store-and-forward capability to ensure data is not lost if the agent becomes disconnected from the cloud.

Returning now to FIG. 5, cloud agent 540 sends compressed data packet 524 to the cloud-based data collection and monitoring system on cloud platform 502 via a cloud storage fabric 516. The data packet 524 conveys parameters and data (compressed and serialized) used by the cloud-side services to reconstruct the domain data structure in the cloud using auxiliary tenant-level manifests. The cloud services direct remote storage of the received data into preconditioned transient blobs 510. The cloud platform 502 can use agent reasoning and collective bargain features to determine a data storage locale.

Through the configuration interface provided by cloud agent 540, users at the plant facility can dynamically configure one or more priority queues 504 that respectively define how the data packets are processed in the cloud platform 502. For example, separate queues may be defined for alarms, live data, and historical data, allowing data to be organized according to these data types. The historical data queue can relate to time-series records, which can be accessed through an application programming interface (API) (e.g., an SQL API or other suitable API). The alarms queue can relate to abnormal situations, where the alarm data can also be accessed through the API. This alarms queue can comprise multiple queues associated with different alarm priorities, to allow for individual processing for different alarms having different levels of criticality. In some embodiments, servers, controllers, switches, etc., can be monitored using a number of protocols, and at a certain point (e.g., at the end of a monitoring cycle) alarms can be queued and cloud agent 540 can send the alarms to the cloud. Alarms can be reactive (e.g., alarms that trigger when a motor fails, when a CPU crashes, when an interlock is tripped, etc.) or proactive (e.g., a monitoring system may track consumables on a machine and generate an alarm when time to reorder, monitor cycle counts on a machine and generate an alarm when to schedule preventative maintenance, generate an alarm when temperatures fall outside defined bandwidths, send a notification when a computer's memory is 80% full, etc.).

The live data queue can relate to substantially real-time monitored data, such as current temperatures, current pressures, etc. The live data values can also be accessed through the API (e.g., a SQL API). The queues described above are not intended to be limiting, and it is to be appreciated that other types of priority queues can be defined according to the needs of the end user. For example, queues may be defined for specific devices or device types (e.g., motor drives) for uploading of device parameter and/or performance data.

In some embodiments, cloud agent 540 can allow the user to define these priority queues 504 from the on-site location and to define how data in each queue is handled. For example, the user can define, for each queue, an upload frequency, a priority level (e.g., which data queues should take processing priority over other data queues), identities of cloud partitions or databases in which data from the respective queues should be stored, and other such information. In an example scenario, the live data queue may be defined to process live data values that are to be used by a remote operator interface application to view substantially real-time data from the plant facility, while historical data queue may be used to process historian data for archival storage in a historical database on cloud storage. Accordingly, the live data queue may be assigned a higher priority relative to the historical data queue, since data in the live data queue is more time-critical than data in the historical queue.

Through cloud agent 540, users can assign priorities to respective data tags or tag groups at the customer site. These priority assignments can be stored in the message queuing database 614 of the cloud agent 540. Accordingly, when queue processing component 604 packages the collected data to be moved to the cloud platform, the collected data items can be packaged into data packets according to priority (as defined in message queuing database 614), and the respective data packet headers populated with the appropriate priority level. If access to the cloud is unavailable, data will continue to be collected by collection services component 602 and stored locally on the cloud agent in local storage associated with collections services. When communication to the cloud is restored, the stored data will be forwarded to cloud storage. Queue processing services can also encrypt and send storage account keys to the cloud platform for user verification.

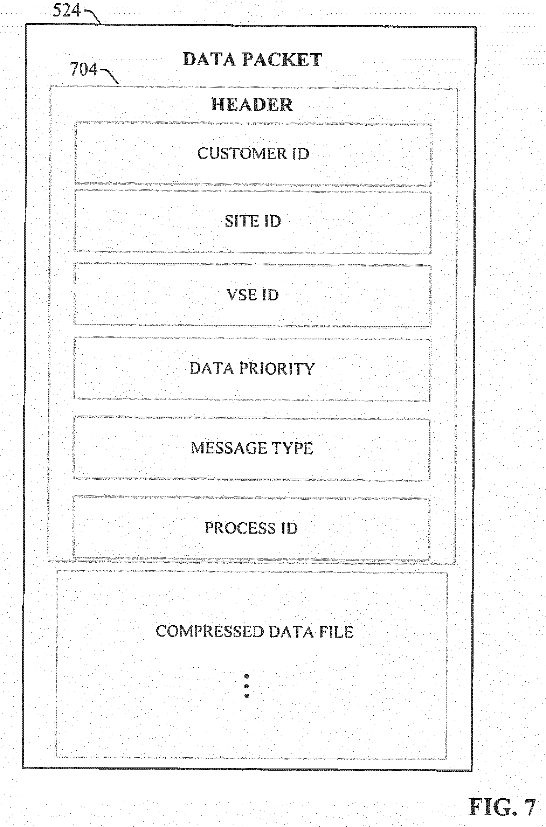

Message queuing services implemented by queue processing component 604 of cloud agent 540 encapsulates or packages the compressed data file by adding customer-specific header information to yield a compressed data packed (e.g., compressed data packet 524 of FIG. 7). For example, the queue processing component 604 can access a message queuing database (e.g., message queuing database 614 of FIG. 6), which stores customer site configuration information and manages the customer's subscription to the cloud platform services. The message queuing database may include such information as a customer identifier associated with the customer entity associated with the industrial enterprise, a site identifier associated with a particular plant facility from which the data was collected, a priority to be assigned to the data (which may be dependent on the type of information being sent; e.g., alarm data, historical data, live operational data, etc.), information required to facilitate connection to the customer's particular cloud fabric, or other such information. The information included in the header is based on this customer-specific information maintained in the message queuing database. An example compressed data packet is illustrated in FIG. 7. As shown, the cloud agent's message queuing services add a header 704 to compressed data file 612 to yield the compressed data packet 524. The header 704 contains customer-specific data read from message queuing database 614. For example, header 704 can include a unique customer identifier, a site identifier representing a particular plant facility, a virtual support engineer identifier, a data priority for the data in the compressed data file 612, a message type, and a process identifier that specifies a particular manifest application on the cloud platform that should be used to process the data on the cloud side. Packaging the data in this way can allow data from diverse data sources to be packaged together using a uniform, generic data packaging schema so that the data can be moved to the cloud infrastructure

When cloud agent 540 sends a data packet to the cloud-based remote processing service, the service reads the packet's header information to determine a priority assigned to the data (e.g., as defined in a data priority field of the data packet) and sends the data packet (or the compressed data therein) to a selected one of the user defined priority queues 504 based on the priority. On the other side of the priority queues 504, a data process service 508 processes data in the respective priority queues 504 according to the predefined processing definitions. The data processing service includes a worker role 532 that determines how the queued data is to be processed based on manifests (e.g., system manifests, tag manifests, and metric manifests) stored in a customer-specific manifest assembly 534. Manifests define and implement customer-specific capabilities, applications, and preferences for processing collected data in the cloud. Manifests can be dynamically uploaded by a user at the plant facility through cloud agent 540, which facilitates dynamic extension of cloud computing capability.

For example, if new data points are to be added to the data collection system that require creation of a new data queue, the user can interact with cloud agent 540 to configure a new manifest for the new queue, the manifest defining such aspects as processing priority for the data, upload frequency for the data, where the data is to be routed or stored within cloud storage, and other such information. Cloud agent 540 can then upload the new manifest 506 together with the data (or independently of the data). The new manifest 506 is then added to the customer's manifest assembly 534 with the other manifests defined for the customer, so that worker role 532 can leverage the new manifest 506 to determine how data in the new queue is to be processed. This new manifest 506 need only be uploaded to the cloud-based remote monitoring service once. Thereafter, data placed in the new priority queue will be processed by worker role 532 according to the new manifest 506 stored in the customer's manifest assembly 534. For example, the manifest may define where the data is to be stored within cloud storage (e.g., in a historical database, and Alarms and Live Data database, big data storage 512, etc.), and whether processing of the new data queue is to take priority over other data queues. In some embodiments, the manifest assembly 534 may only accept a new manifest if the manifest is accompanied by a unique key associated with the client.

Once the cloud-based infrastructure has processed and stored the data provided by cloud agent 540 according to the techniques described above, the data can be made accessible to client devices 520 for viewing. Data analysis on the cloud platform 502 (e.g., the multi-tier cyber analytics system described herein) can provide a set of web-based and browser enabled technologies for retrieving, directing, and uncompressing the data from the cloud platform 502 to the client devices 520. To this end, reporting services 514 can deliver data in cloud storage (e.g., from the big data storage 512) to the client devices 520 in a defined format. For example, reporting services 514 can leverage collected data stored in the cloud repository to provide remote operator interfaces to client devices 520 over the Internet. An analytic engine 518 executing on the cloud platform 502 can also perform various types of analysis on the data stored in big data storage 512 and provide results to client devices 520. Analytics services that can act on the collected data can include, for example, the emulation-based analytics system to be described in more detail herein

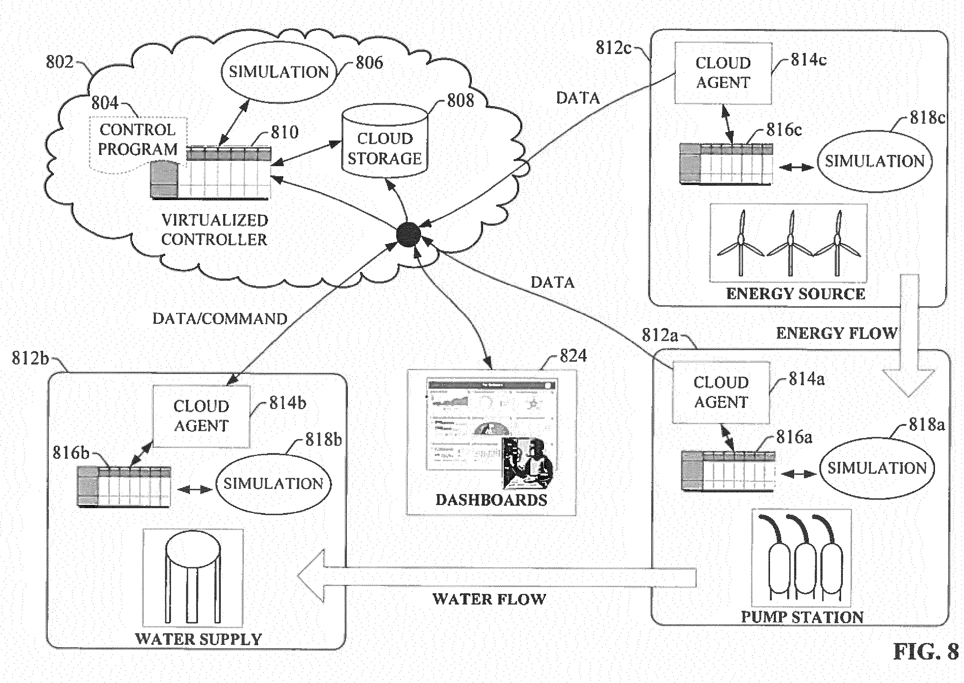

FIG. 8 is a diagram of a general architecture for a multi-tier cyber analytics system that executes on a cloud platform and interfaces hardware control systems and simulations at multiple locations with cloud-level analytics services. In this example, three inter-related and geographically diverse facilities 812a-812c are linked to the cloud-based architecture using cloud agents 814a-814c and cloud services. A pump station 812a pumps water to a water supply facility 812b. An energy source facility 812c provides energy to the pump station 812a to run the pumping equipment. These three facilities can be separated by several miles. Systems at each facility are controlled by respective industrial controllers 816a-816c. In some scenarios, plant engineers at each of the facilities 812a-812c may develop and execute simulations 818a-818c that model aspects of plant operations. These simulations 818a-818c interact with the control programs executing on the respective industrial controllers 816a-816c to perform plant-level validation, modeling, and/or analytics.

Cloud agents 814a-814c link the industrial controllers 816a-816c to the cloud platform 802. The cloud agents may also link other devices to the cloud platform, including but not limited to other industrial devices or on-premise data historians. The cloud agents 814a-814c push real-time and historical data from the controllers 816a-816c (and possibly other devices) to the cloud platform 802, where cloud services (e.g., the worker role 532 described above) can move the received data in cloud storage 808.

According to one or more embodiments, the emulation component of the cloud-based industrial emulation and analytics system can execute a virtualized controller 810 on the cloud platform 802. The virtualized controller 810 is driven by a controller engine that serves as the core component of the cloud-based industrial analytics system, and runs on an industrial controller emulation platform that allows the virtualized controller 810 to be programmed using the same programming tools used to program hardware controllers 816a-816c. This allows the virtualized controller to be programmed and configured by plant engineers, rather than requiring the services of a data scientist or cloud analytics specialist.

The virtualized controller 810, executing control program 804 on the cloud platform 802, serves as an enterprise-level controller that monitors the three facilities 812a-812c (by monitoring and processing the data collected from the three facilities and stored on cloud storage 808) and performs enterprise-level decision-making based on the control program 804. Based on the monitoring performed by virtualized controller 810, the cloud-based analytics system can generate and deliver recommendations for modifying operations of one or more of the facilities 812a-812c via dashboards 824. In some embodiments in which one or more of the cloud agents 814 support bi-directional data exchange with the cloud platform, the virtualized controller 810 may deliver automated control commands to one or more of the controllers 816a-816c in accordance with the control program 804. For example, all three cloud agents 814a-814c may be configured to provide data to the cloud platform for storage and analysis, while cloud agent 814a at the pump station 812a may be additionally configured to receive commands or other information from the analytics system. With this configuration, virtualized controller 810 can send commands to on-premise industrial controller 816a via cloud agent 814a based on the enterprise-level monitoring and control carried out by control program 804. These commands can include, for example, adjustments to setpoints or other analog values, selection of different control routines to be executed by controller 816a, setting or resetting of control bits, or other such commands. In this way, plant-level control carried out by controllers 816a-816c is supplemented by enterprise-level control performed by virtualized controller 810 in the cloud platform 802.

As noted above, the control program 804 can be configured using the same programming platform as that used to program the on-premise hardware controllers 816a-816c (e.g., ladder logic, sequential function chart, structured text, etc.). Since selected data items from all three facilities are made available on cloud storage 808, the control program 804 can be designed to correlate relevant metrics between the facilities and generate recommended operational modifications based on the analysis. In an example scenario, a plant manager may wish to optimize energy consumption by the pump station 812a while maintaining a minimum water level in water supply facility 812b. Additional criteria may also be programmed in to the virtualized controller 810. For example, the virtualized controller 810 may be programmed to enforce a limit on hourly energy usage by pump station 812a during certain peak demand times, while enforcing a minimum water level at water supply facility 812b - without regard for energy consumption - during other times. In general, virtualized controller 810 can be programmed to implement substantially any enterprise-level monitoring and/or control conditions by executing control program 804 and leveraging the multi-facility data maintained in cloud storage 808.

Users can interact with the cloud-based analytics system via dashboards 824 or other user interfaces, which can be served by client interface component 414 to authorized users via their Internet-capable personal devices (e.g., desktop, laptop, or tablet computers, mobile phones, etc.). These dashboards 824 can include graphical screens that render selected subsets of the multi-facility data maintained on cloud storage 808, calculated operational statistics (e.g., key performance indicators, production statistics, energy cost and/or consumption data, etc.), analysis results, reports, recommendations for optimizing one or more performance parameters, etc. The dashboards 824 can also display configurations screens that allow the user to view and modify the control program 804 executing on virtualized controller 810. As noted above, the virtualized controller 810 is hosted by an emulation component that emulates the operation of a hardware industrial controller on the cloud platform. The emulation component allows the virtualized controller 810 to be programmed using a standard control programming language (e.g., ladder logic, sequential function chart, structured text, etc.).

The simulation component 410 of the cloud-based emulation and analytics system can also execute a cloud-based simulation 806 that models one or more aspects of the distributed system comprising facilities 812a-812c. Simulation 806 interacts with virtualized controller 810 and can function in a manner similar to simulation 104 described above. For example, simulation 806 can be developed to model a test operation scenario for the distributed facilities 812a-812c being considered. Virtualized controller 810 can be programmed to monitor and control the test scenario via interaction with the simulation 806, and generate results indicating one or more performance parameters or outcomes based on the simulation. These simulation results can include, but are not limited to, estimates of production rates at one or more of the facilities (which may be a function of performance parameters at other inter-related facilities), energy cost or consumption rates, quality metrics, operating costs, key performance indicators (KPIs), determinations of whether certain specified operational requirements will be met by the proposed system being simulated (e.g., whether the pump station 812a will satisfy the demand of the water supply facility 812b at all times if a change in pump station operation intended to reduce energy consumption is implemented), or other such indications.

In some embodiments, simulation 806 can be developed by the user to simulate a specific operating scenario of interest. In another scenario, the analytics system's simulation component 410 can automatically identify possible alternative operating scenarios for optimizing or improving one or more key performance indicators (e.g., energy consumption) and model these proposed operating scenarios in simulation 806. The analytics component 412 can then test this simulated operating scenario based on interaction between the simulation 806 and virtualized controller 810. The simulation component 410 and analytics component 412 may model and test multiple operating scenarios in an iterative fashion until an optimal result for the performance indicator of interest is identified. The analytics system can then deliver - via dashboards 824 - one or more recommendations for implementing the operating scenario determined to achieve the optimal result. For example, the system may inform the user that lowering the minimum water level to be maintained at the water supply facility 812b to a specified level for certain hours of the day will reduce energy costs while still meeting the expected water demand. The user can then decide whether to apply the recommendation based on the information provided in the recommendation; e.g., by changing the target water level set point at the pump station for the indicated hours. For systems that support bi-directional communication between the cloud-based analytics system and one or more of the cloud agents 814a-814c, the analytics system can deliver a command to cloud agent 814a to modify the appropriate set point in industrial controller 816a.

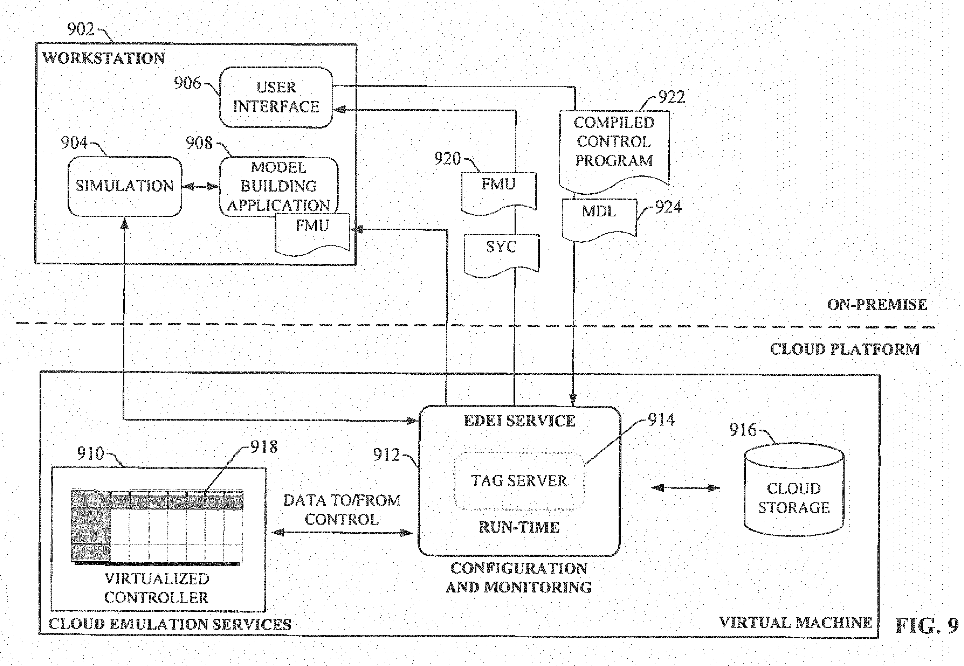

In some configurations, the on-premise simulations 818a-818c can interact with the virtualized controller 810 via their respective cloud agents 814a-814c to implement a distributed simulation scenario. In such scenarios, the virtualized controller 810 can perform enterprise-level monitoring and control of the on-premise simulations 818a-818c via cloud agents 814a-814c and generate simulation results similar to those described above for the cloud-based simulation scenario. This coordinated interaction with distributed simulations is achieved using the emulation data exchange interface (EDEI) of the emulation runtime engine on the cloud platform. FIG. 9 is a diagram illustrating runtime of the EDEI service of the cloud-based cyber analytics system. In this example, workstation 902 - which may be any suitable on-premise computing device, including but not limited to a desktop, laptop, or table computer - executes a simulation 904, which models at least a portion of an industrial system to be tested. The simulation 904 may be generated and maintained by a model building application 908. On the cloud platform, emulation services 910 provided by the emulation component execute virtualized controller 918, as described in previous examples. The on-premise simulation 904 exchanges information with virtualized controller 918 executing on the cloud platform via the EDEI service 912. The EDEI service 912 provides connectivity among the API of the cloud emulation services 910, simulation 904, and other cloud services executing on the cloud platform.

EDEI service 912 includes a tag server 914 that maps I/O data for streaming to and from the cloud platform. The tag server 914 acts as a real-time interface between virtualized controller 918 and external on-premise devices. In this example, tag server 914 defines data to be exchanged between simulation 904 on workstation 902 and the virtualized controller 918 executed by the cloud emulation services 910. However, the tag server 914 can also define data mappings between virtualized controller 918 and other devices, including but not limited to on-premise industrial controllers or other industrial devices. To facilitate mapping between simulation data points and virtualized I/O points of the virtualized controller 918, the user may provide information regarding the simulation model - e.g., an MDL file 924 - to the EDEI service 912. Tag server 914 may use information contained in the MDL file 924 to link simulation I/O points with I/O points of the virtualized controller. Based on the I/O data mapping defined by the tag server 914, the on-premise cloud agent (not shown) that connects workstation 902 to the cloud platform will stream the defined data items to the EDEI service 912 on the cloud platform and process commands from the virtualized controller 918 via the EDEI service 912.

A functional mock-up unit (FMU) is established by exchange of FMU files 920 between EDEI service 912 and simulation 904. Virtualized controller 918 can be programmed remotely using workstation 902, which executes a standard industrial controller programming platform (e.g., a ladder logic development platform). In particular, a user at workstation 902 can develop a control program (e.g., control program 804 of FIG. 8) and send the compiled control program 922 to the EDEI service 912, which passes the control program to the virtualized controller for execution.

During runtime, tag server 914 streams data between simulation 904 on the on-premise workstation 902 and virtualized controller 918 on the cloud platform via the on-premise cloud agent device. The EDEI service 912 may also leverage cloud storage 916 to retrieve or store data relating to the simulation session. The simulation session may be monitored by a user via a dashboard (e.g., dashboard 824) or other graphical interface served to the user's client device. Based on results of the simulation session, the analytics system can generate recommendations for modifying one or more aspects of the modeled industrial system or process to optimize one or more performance or business metrics.

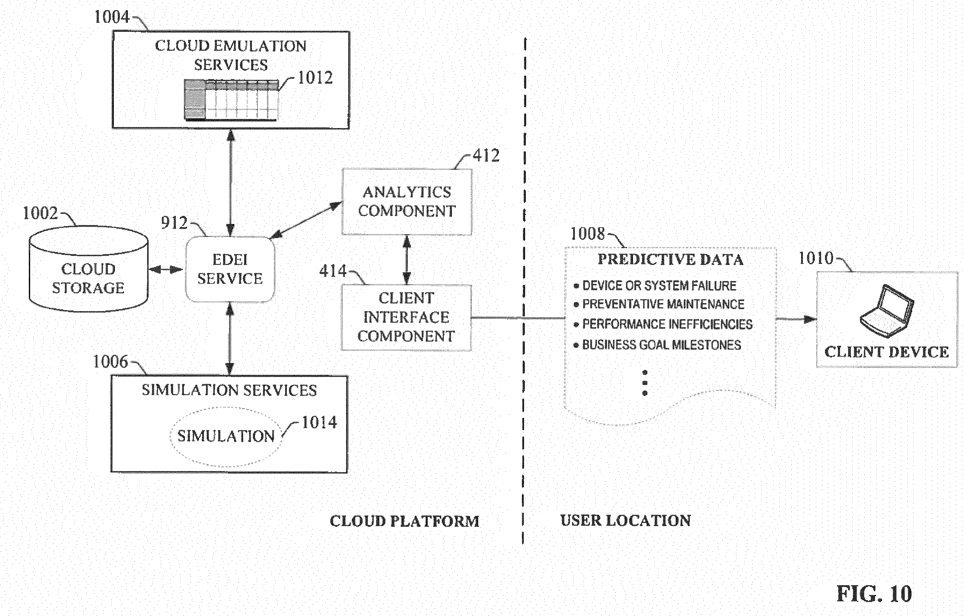

If simulation 904 is a model of a live system, the analytics system may perform predictive analysis based on results of the simulation session. FIG. 10 is a diagram illustrating delivery of predictive data by the cloud-based cyber analytics system. As described in previous examples, cloud emulation services 1004 execute a virtualized controller 1012, which interacts with a cloud-based simulation 1014 executed by the cloud platform's simulation services 1006. Simulation 1014 models at least a portion of an industrial system or one or more distributed industrial systems. EDEI service 912 provides connectivity between simulation 1014, virtualized controller 1012, and cloud storage 1002, which stores data collected from the industrial system(s) by the tag server of the EDEI service.

During a simulation session, simulation 104 exchanges information with virtualized controller 1012 to simulate operation of the modeled industrial system(s). Analytics component 412 monitors the simulation session and estimates possible system responses (e.g., responses as a function of time) that may warrant notification of plant personnel. For example, based on results of the simulation, the analytics component 412 may identify an impending system or device failure or inefficiency. This identified issue may be based on simulation of system behavior over time correlated with learned system performance indicators that typically presage such failures. In some embodiments, the analytics component 412 can learn these critical system performance indicators through big data pattern recognition analysis performed on the collected industrial data maintained in cloud storage 1002. Analytics component 412 may also predict performance trends or estimate when a specified business goal will be achieved (e.g., when a target product count or cost efficiency metric will be satisfied).

Client interface component 414 can deliver predictive analysis results to a client device 1010 as predictive data 1008 (e.g., via dashboards or other user interfaces). In some scenarios, the user can request the predictive information by invoking a dashboard or other graphical interface served by client interface component 414. Through such interfaces, the client interface component 414 can deliver reports identifying predicted device or system failures or inefficiencies, preventative maintenance schedules generated based on predicted system or device performance trend data, reports indicating when selected business goal milestones will be reached, or other such predictive data.

In some embodiments, the client interface component 414 may deliver automated notifications in response to identifying an impending system or device issue requiring attention. For example, based on a correlation of near real-time system data in cloud storage 1002 indicative of current states of the on-premise industrial system(s) with performance trends identified based on one or more cloud-based simulations of the user's systems, analytics component 412 can determine that a key performance metric is at risk of falling outside a desired tolerance in the near future. Based on this determination, client interface component can deliver a notification to one or more client devices associated with specified maintenance or engineering personnel. The notification can include a maintenance recommendation indicating a process or device adjustment designed to keep the performance indicator within the preferred tolerance.

In some embodiments, client interface component 414 can deliver maintenance notifications in accordance with notification preferences specified in a customer model maintained on the cloud platform. These notification preferences can be defined as a function of the type of maintenance issue for which a notification is to be generated. For example, the customer model may specify that notifications relating to an impending device failure should be delivered to one or more client devices associated with selected maintenance personnel, while notifications relating to firmware upgrades or recommended device reconfigurations should be delivered to a client device associated with a plant engineer. Notification preferences defined in the customer model may also be a function of a particular plant facility, area, or workcell to which the notification relates. Once the appropriate client devices to be notified have been determined, client interface component 414 can deliver maintenance notifications to the one or more notification destinations. The notifications can be sent to identified Internet-capable client devices, such as phones, tablet computers, desktop computers, or other suitable devices.

In some embodiments, rather than or in addition to issuance of the notification, the cloud-based analytics system may automatically implement the recommended changes on the customer's equipment via the cloud. For example, if the relevant industrial devices are communicating with the cloud platform via a bi-directional cloud agent, the cloud-based analytics system can issue instructions or configuration data to the devices via the cloud agent that implement the recommended adjustment on the device. Such remotely administered instructions can implement setpoint adjustments, alter configuration settings, initiate execution of selected subroutines in on on-premise industrial controller, etc.

The systems described above provide high-speed cloud-based analytics for industrial automation that can be implemented and maintained without the need for a cloud analytics specialist or data scientist. The cloud-based controller emulation engine allows a virtualized controller in the cloud to be configured and programmed using controller programming tools familiar to plant engineers, and permits coordinated interaction with distributed simulations via the EDEI. The analytics system provides virtual control design and validation as a service in the cloud.

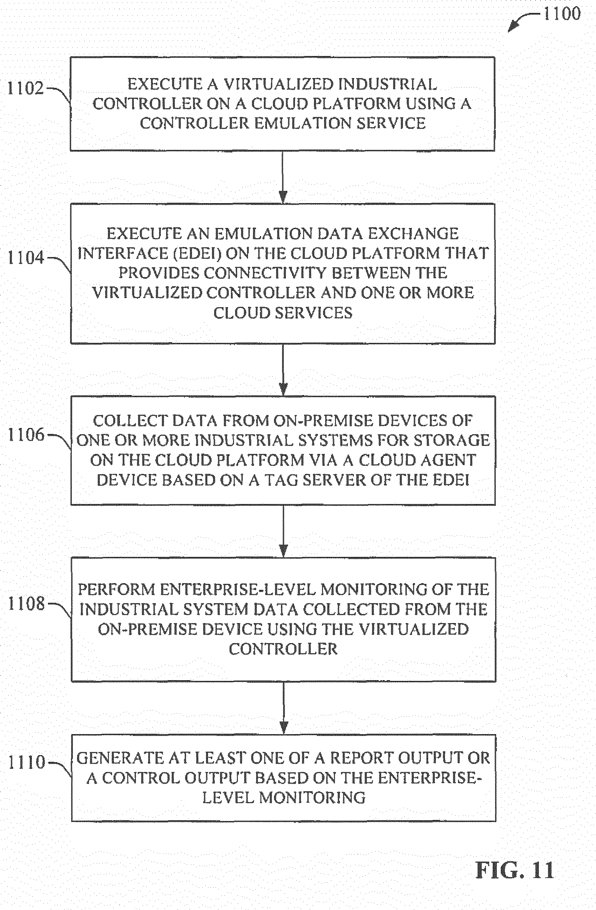

FIGs 11-13 illustrate various methodologies in accordance with one or more embodiments of the subject application. While, for purposes of simplicity of explanation, the one or more methodologies shown herein are shown and described as a series of acts, it is to be understood and appreciated that the subject innovation is not limited by the order of acts, as some acts may, in accordance therewith, occur in a different order and/or concurrently with other acts from that shown and described herein. For example, those skilled in the art will understand and appreciate that a methodology could alternatively be represented as a series of interrelated states or events, such as in a state diagram. Moreover, not all illustrated acts may be required to implement a methodology in accordance with the innovation. Furthermore, interaction diagram(s) may represent methodologies, or methods, in accordance with the subject disclosure when disparate entities enact disparate portions of the methodologies. Further yet, two or more of the disclosed example methods can be implemented in combination with each other, to accomplish one or more features or advantages described herein.

FIG. 11 illustrates an example methodology 1100 for implementing enterprise-level supervisory monitoring of one or more industrial systems using cloud services. Initially, at 1102, a virtualized industrial controller is executed on a cloud platform using a controller emulation service. The virtualized controller can run supervisory control program (e.g., ladder logic) for monitor and/or control of one or more on-premise industrial systems. The emulation service allows a user to program the virtualized controller using the same control program development tool used to program a hardware controller such as a PLC.

At 1104, an emulation data exchange interface (EDEI) is executed on the cloud platform. The EDEI provides connectivity between the virtualized controller and one or more cloud services. These services may include, for example, worker roles that determines how queued data collected from one or more industrial systems is to be processed based, web roles, cloud storage and data queues, or other such services. At 1106, data is collected from on-premise devices of one or more industrial systems for storage on the cloud platform. The data can be collected, for example, via one or more cloud agent devices based on a tag server included in the EDEI, which manages streaming of on-premise data to the cloud platform for storage, monitoring, and processing. The data may be collected from on-premise industrial controllers that perform plant-level monitoring and control of the one or more industrial systems, or from other on-premise industrial devices (e.g., telemetry devices, motor drives, etc.).

At 1108, enterprise-level monitoring of the industrial system data collected at step 1106 is performed using the virtualized controller. In this regard, the EDEI facilitates connectivity between the virtualized controller and the real-time and historical data maintained in cloud storage, allowing the virtualized controller to effectively monitor the plant-level industrial systems from the cloud platform. At 1110, at least one of a report output or a control output is generated based on the enterprise-level monitoring. The report output may be delivered to one or more client devices with authorized access to the cloud services, and may comprise, for example, a human-machine interface or graphical report that renders plant-level or enterprise-level information about the industrial systems (e.g., key performance indicators, production statistics, energy usage information, alarm information, machine downtime information, etc.). For systems that support bi-directional data exchange between the cloud-based analytics system and the on-premise devices (e.g., via the cloud agent devices), the control output may comprise an instruction to one or more hardware industrial controllers associated with the industrial controllers. For example, based on the enterprise-level supervisory analysis performed on the cloud platform, the virtualized controller may send a command to an on-premise industrial controller to adjust a setpoint value, modify a control sequence, execute a different control routine, or other such operational changes.

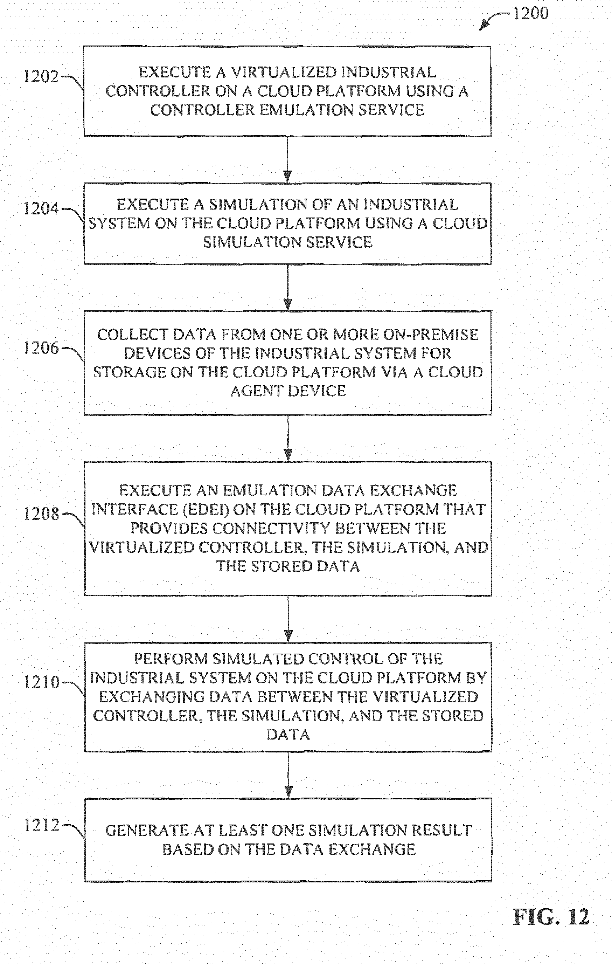

FIG. 12 illustrates an example methodology 1200 for simulating an industrial system on a cloud platform. Initially, at 1202, a virtualized industrial controller is executed on a cloud platform using a controller emulation service. At 1204, a simulation of an industrial system is executed on the cloud platform using a cloud simulation service. At 1206, data is collected from one or more on-premise devices of the industrial system for storage on the cloud platform. For example, data collection services executing on the cloud platform can interface with the on-premise devices via a cloud agent device, and can stream the data from the devices to the cloud platform based on an I/O mapping defined by a tag server executing on the cloud platform.

At 1208, an emulation data exchange interface (EDEI) is executed on the cloud platform, the EDEI providing connectivity between the virtualized controller, the simulation, and the stored data. At 1210, simulated control of the industrial system is performed on the cloud platform by exchanging data (via the EDEI) between the virtualized controller, the simulation, and the stored data. At 1212, at least one simulation result is generated based on the data exchange.

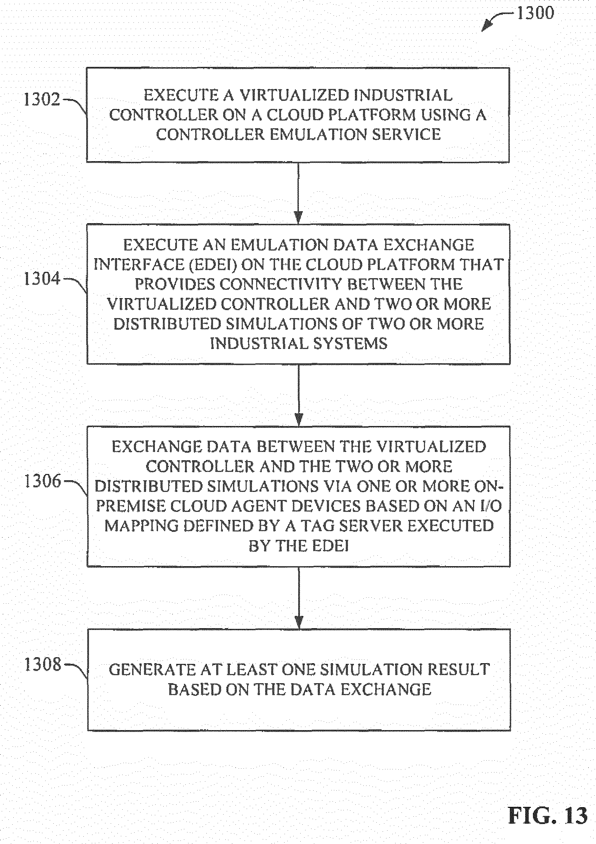

FIG. 13 illustrates an example methodology 1300 for interfacing distributed on-premise simulations with a virtualized controller executing on a cloud platform. Initially, at 1302, a virtualized industrial controller is executed on a cloud platform using a controller emulation service. At 1304, an emulation data exchange interface (EDEI) is executed on the cloud platform, the EDEI providing connectivity between the virtualized controller and two or more distributed simulations of respective two or more industrial systems.

At 1306, data is exchanged between the virtualized controller and the two or more distributed simulations via one or more cloud agent devices based on an I/O mapping defined by a tag server executed by the EDEI. The connectivity provided by the EDEI allows a collective enterprise-level simulation of the distributed industrial system simulations to be performed on the cloud platform. At 1308, at least one simulation result is generated based on the data exchange.

Embodiments, systems, and components described herein, as well as industrial control systems and industrial automation environments in which various aspects set forth in the subject specification can be carried out, can include computer or network components such as servers, clients, programmable logic controllers (PLCs), automation controllers, communications modules, mobile computers, wireless components, control components and so forth which are capable of interacting across a network. Computers and servers include one or more processors-electronic integrated circuits that perform logic operations employing electric signals-configured to execute instructions stored in media such as random access memory (RAM), read only memory (ROM), a hard drives, as well as removable memory devices, which can include memory sticks, memory cards, flash drives, external hard drives, and so on.

Similarly, the term PLC or automation controller as used herein can include functionality that can be shared across multiple components, systems, and/or networks. As an example, one or more PLCs or automation controllers can communicate and cooperate with various network devices across the network. This can include substantially any type of control, communications module, computer, Input/Output (I/O) device, sensor, actuator, and human machine interface (HMI) that communicate via the network, which includes control, automation, and/or public networks. The PLC or automation controller can also communicate to and control various other devices such as standard or safety-rated I/O modules including analog, digital, programmed/intelligent I/O modules, other programmable controllers, communications modules, sensors, actuators, output devices, and the like.

The network can include public networks such as the internet, intranets, and automation networks such as control and information protocol (CIP) networks including DeviceNet, ControlNet, and Ethernet/IP. Other networks include Ethernet, DH/DH+, Remote I/O, Fieldbus, Modbus, Profibus, CAN, wireless networks, serial protocols, and so forth. In addition, the network devices can include various possibilities (hardware and/or software components). These include components such as switches with virtual local area network (VLAN) capability, LANs, WANs, proxies, gateways, routers, firewalls, virtual private network (VPN) devices, servers, clients, computers, configuration tools, monitoring tools, and/or other devices.

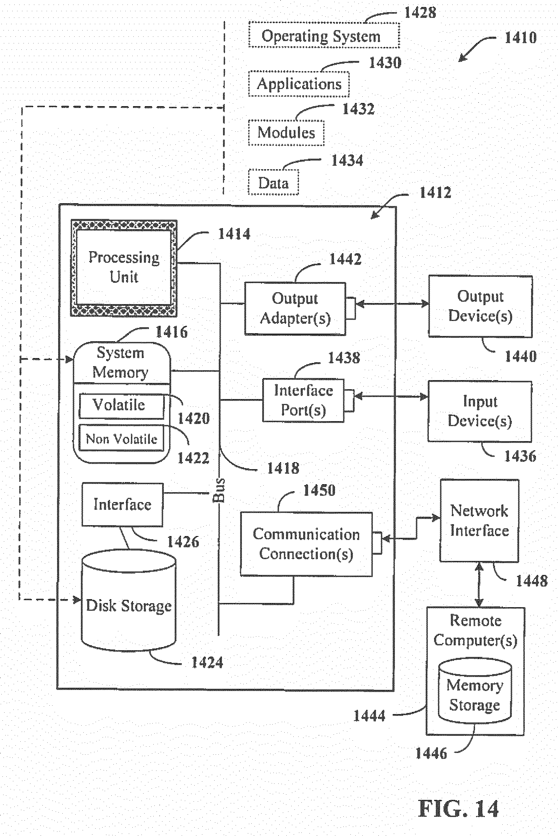

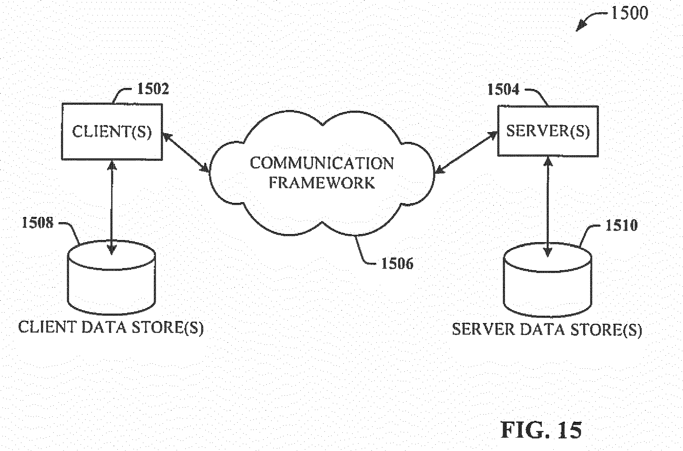

In order to provide a context for the various aspects of the disclosed subject matter, FIGs. 14 and 15 as well as the following discussion are intended to provide a brief, general description of a suitable environment in which the various aspects of the disclosed subject matter may be implemented.

With reference to FIG. 14, an example environment 1410 for implementing various aspects of the aforementioned subject matter includes a computer 1412. The computer 1412 includes a processing unit 1414, a system memory 1416, and a system bus 1418. The system bus 1418 couples system components including, but not limited to, the system memory 1416 to the processing unit 1414. The processing unit 1414 can be any of various available processors. Multi-core microprocessors and other multiprocessor architectures also can be employed as the processing unit 1414.

The system bus 1418 can be any of several types of bus structure(s) including the memory bus or memory controller, a peripheral bus or external bus, and/or a local bus using any variety of available bus architectures including, but not limited to, 8-bit bus, Industrial Standard Architecture (ISA), Micro-Channel Architecture (MSA), Extended ISA (EISA), Intelligent Drive Electronics (IDE), VESA Local Bus (VLB), Peripheral Component Interconnect (PCI), Universal Serial Bus (USB), Advanced Graphics Port (AGP), Personal Computer Memory Card International Association bus (PCMCIA), and Small Computer Systems Interface (SCSI).

The system memory 1416 includes volatile memory 1420 and nonvolatile memory 1422. The basic input/output system (BIOS), containing the basic routines to transfer information between elements within the computer 1412, such as during start-up, is stored in nonvolatile memory 1422. By way of illustration, and not limitation, nonvolatile memory 1422 can include read only memory (ROM), programmable ROM (PROM), electrically programmable ROM (EPROM), electrically erasable PROM (EEPROM), or flash memory. Volatile memory 1420 includes random access memory (RAM), which acts as external cache memory. By way of illustration and not limitation, RAM is available in many forms such as synchronous RAM (SRAM), dynamic RAM (DRAM), synchronous DRAM (SDRAM), double data rate SDRAM (DDR SDRAM), enhanced SDRAM (ESDRAM), Synchronous Link DRAM (SLDRAM), and direct Rambus RAM (DRRAM).

Computer 1412 also includes removable/non-removable, volatile/nonvolatile computer storage media. FIG. 14 illustrates, for example a disk storage 1424. Disk storage 1424 includes, but is not limited to, devices like a magnetic disk drive, floppy disk drive, tape drive, Jaz drive, Zip drive, LS-100 drive, flash memory card, or memory stick. In addition, disk storage 1424 can include storage media separately or in combination with other storage media including, but not limited to, an optical disk drive such as a compact disk ROM device (CD-ROM), CD recordable drive (CD-R Drive), CD rewritable drive (CD-RW Drive) or a digital versatile disk ROM drive (DVD-ROM). To facilitate connection of the disk storage 1424 to the system bus 1418, a removable or non-removable interface is typically used such as interface 1426.

It is to be appreciated that FIG. 14 describes software that acts as an intermediary between users and the basic computer resources described in suitable operating environment 1410. Such software includes an operating system 1428. Operating system 1428, which can be stored on disk storage 1424, acts to control and allocate resources of the computer 1412. System applications 1430 take advantage of the management of resources by operating system 1428 through program modules 1432 and program data 1434 stored either in system memory 1416 or on disk storage 1424. It is to be appreciated that one or more embodiments of the subject disclosure can be implemented with various operating systems or combinations of operating systems.

A user enters commands or information into the computer 1412 through input device(s) 1436. Input devices 1436 include, but are not limited to, a pointing device such as a mouse, trackball, stylus, touch pad, keyboard, microphone, joystick, game pad, satellite dish, scanner, TV tuner card, digital camera, digital video camera, web camera, and the like. These and other input devices connect to the processing unit 1414 through the system bus 1418 via interface port(s) 1438. Interface port(s) 1438 include, for example, a serial port, a parallel port, a game port, and a universal serial bus (USB). Output device(s) 1440 use some of the same type of ports as input device(s) 1436. Thus, for example, a USB port may be used to provide input to computer 1412, and to output information from computer 1412 to an output device(s) 1440. Output adapters 1442 are provided to illustrate that there are some output devices 1440 like monitors, speakers, and printers, among other output devices 1440, which require special adapters. The output adapters 1442 include, by way of illustration and not limitation, video and sound cards that provide a means of connection between the output device 1440 and the system bus 1418. It should be noted that other devices and/or systems of devices provide both input and output capabilities such as remote computer(s) 1444.

Computer 1412 can operate in a networked environment using logical connections to one or more remote computers, such as remote computer(s) 1444. The remote computer(s) 1444 can be a personal computer, a server, a router, a network PC, a workstation, a microprocessor based appliance, a peer device or other common network node and the like, and typically includes many or all of the elements described relative to computer 1412. For purposes of brevity, only a memory storage device 1446 is illustrated with remote computer(s) 1444. Remote computer(s) 1444 is logically connected to computer 1412 through a network interface 1448 and then physically connected via communication connection(s) 1450. Network interface 1448 encompasses communication networks such as local-area networks (LAN) and wide-area networks (WAN). LAN technologies include Fiber Distributed Data Interface (FDDI), Copper Distributed Data Interface (CDDI), Ethernet/IEEE 802.3, Token Ring/IEEE 802.5 and the like. WAN technologies include, but are not limited to, point-to-point links, circuit switching networks like Integrated Services Digital Networks (ISDN) and variations thereon, packet switching networks, and Digital Subscriber Lines (DSL).

Communication connection(s) 1450 refers to the hardware/software employed to connect the network interface 1448 to the system bus 1418. While communication connection(s) 1450 is shown for illustrative clarity inside computer 1412, it can also be external to computer 1412. The hardware/software necessary for connection to the network interface 1448 includes, for exemplary purposes only, internal and external technologies such as, modems including regular telephone grade modems, cable modems and DSL modems, ISDN adapters, and Ethernet cards.

FIG. 15 is a schematic block diagram of a sample computing environment 1500 with which the disclosed subject matter can interact. The sample computing environment 1500 includes one or more client(s) 1502. The client(s) 1502 can be hardware and/or software (e.g., threads, processes, computing devices). The sample computing environment 1500 also includes one or more server(s) 1504. The server(s) 1504 can also be hardware and/or software (e.g., threads, processes, computing devices). The servers 1504 can house threads to perform transformations by employing one or more embodiments as described herein, for example. One possible communication between a client 1502 and servers 1504 can be in the form of a data packet adapted to be transmitted between two or more computer processes. The sample computing environment 1500 includes a communication framework 1506 that can be employed to facilitate communications between the client(s) 1502 and the server(s) 1504. The client(s) 1502 are operably connected to one or more client data store(s) 1508 that can be employed to store information local to the client(s) 1502. Similarly, the server(s) 1504 are operably connected to one or more server data store(s) 1510 that can be employed to store information local to the servers 1504.

What has been described above includes examples of the subject innovation. It is, of course, not possible to describe every conceivable combination of components or methodologies for purposes of describing the disclosed subject matter, but one of ordinary skill in the art may recognize that many further combinations and permutations of the subject innovation are possible. Accordingly, the disclosed subject matter is intended to embrace all such alterations, modifications, and variations that fall within the scope of the appended claims.

In particular and in regard to the various functions performed by the above described components, devices, circuits, systems and the like, the terms (including a reference to a "means") used to describe such components are intended to correspond, unless otherwise indicated, to any component which performs the specified function of the described component (e.g., a functional equivalent), even though not structurally equivalent to the disclosed structure, which performs the function in the herein illustrated exemplary aspects of the disclosed subject matter. In this regard, it will also be recognized that the disclosed subject matter includes a system as well as a computer-readable medium having computer-executable instructions for performing the acts and/or events of the various methods of the disclosed subject matter.

In addition, while a particular feature of the disclosed subject matter may have been disclosed with respect to only one of several implementations, such feature may be combined with one or more other features of the other implementations as may be desired and advantageous for any given or particular application. Furthermore, to the extent that the terms "includes," and "including" and variants thereof are used in either the detailed description or the claims, these terms are intended to be inclusive in a manner similar to the term "comprising."

In this application, the word "exemplary" is used to mean serving as an example, instance, or illustration. Any aspect or design described herein as "exemplary" is not necessarily to be construed as preferred or advantageous over other aspects or designs. Rather, use of the word exemplary is intended to present concepts in a concrete fashion.

Various aspects or features described herein may be implemented as a method, apparatus, or article of manufacture using standard programming and/or engineering techniques. The term "article of manufacture" as used herein is intended to encompass a computer program accessible from any computer-readable device, carrier, or media. For example, computer readable media can include but are not limited to magnetic storage devices (e.g., hard disk, floppy disk, magnetic strips...), optical disks [e.g., compact disk (CD), digital versatile disk (DVD)...], smart cards, and flash memory devices (e.g., card, stick, key drive...).

## Claims

1. A system (402) for performing industrial analytics, comprising:
a memory (418) that is configured to store computer-executable components; and
a processor (416), operatively coupled to the memory, that is configured to execute the computer-executable components, the computer-executable components comprising:
an emulation component (406, 910, 1004) configured to execute a virtualized industrial controller (810) on a cloud platform (302, 502, 802), wherein the virtualized industrial controller is configured to execute a control program (804) for monitoring operation of one or more industrial controllers (816a, 816b, 816c), wherein the control program defines at least one operational constraint to be applied to the one or more industrial controllers;
a simulation component (410, 1006) configured to execute a simulation (806, 1014) of an industrial system on the cloud platform;
an emulation data exchange component (408) configured to execute an emulation data exchange interface, EDEI (912), for communicatively connecting the virtualized industrial controller (810, 918, 1012) and the simulation; and
an analytics component (412, 518) configured to:
generate output data directed to a client device (520, 1010) via the cloud platform based on analysis of a simulation session performed by the simulation and the virtualized industrial controller and
send a command output to at least one industrial controller of the one or more
industrial controllers based on analysis of the operation of the one or more industrial controllers and the operational constraint.

2. The system of claim 1, wherein the EDEI (912) comprises a tag server (914) that is configured to define data items to be collected from one or more industrial devices (308, 310) and stored on cloud storage (512, 808, 916), and the EDEI is further configured to communicatively connect the virtualized industrial controller (810) and the cloud storage.

3. The system of claim 2, wherein the EDEI (912) is further configured to collect at least a subset of the data items from the one or more industrial controllers (816a, 816b, 816c) via a cloud agent device (306_1, 306_N, 540, 814a, 814b, 814c) residing at respective one or more plant facilities (304_1, 304_N, 812a, 812b, 812c).

4. The system of claim 1, wherein the control program (804), executed by the virtualized industrial controller (810), is configured to monitor, via the EDEI (912), simulated input data from the simulation and send, via the EDEI, simulated output data to the simulation (806) to facilitate monitoring and control of the simulation, and the output data comprises a recommendation for modifying the industrial system based on analysis of the simulation in response to the monitoring and control by the virtualized industrial controller.

5. The system of claim 3, wherein the control program (804), executed by the virtualized industrial controller (810), is configured to monitor the operation of the one or more industrial controllers (816a, 816b, 816c) based on at least the subset of the data items, wherein the virtualized industrial controller reads at least the subset of the data items via the EDEI (912).

6. The system of claim 5, wherein the analytics component (412, 518) is further configured to generate recommendation data indicating a recommendation for altering one or more processes being controlled by the one or more industrial controllers (816a, 816b, 816c) based on analysis of the operation of the one or more industrial controllers.

7. The system of claim 5, wherein the command output comprises at least one of a command to alter a setpoint, a command to execute a different control routine on the at least one industrial controller, or a command to alter a control sequence performed by the at least one industrial controller.

8. A method for analyzing performance of an industrial system, comprising:
executing, by a system (402) comprising at least one processor (416), a virtualized industrial controller (810) on a cloud platform (302, 502, 802), wherein the virtualized industrial controller executes a control program (804) for monitoring operation of one or more industrial controllers (816a, 816b, 816c), wherein the control program defines at least one operational constraint to be applied to the one or more industrial controllers;
executing, by the system, a simulation (806, 1014) of an industrial system on the cloud platform;
executing, by the system, an emulation data exchange interface, EDEI (912), that facilitates exchange of simulation data between the virtualized industrial controller and the simulation;
performing, by the system, analytics on a simulation session performed by the virtualized industrial controller and the simulation;
sending, by the system, output data to a client device via the cloud platform based on the analytics; and
sending a command output to at least one industrial controller of the one or more industrial controllers based on analysis of the operation of the one or more industrial controllers and the operational constraint.

9. The method of claim 8, further comprising:
collecting industrial data from one or more industrial devices (308_1, 310_2, 308_N, 310_1, 310_2, 310_N) located at one or more industrial facilities (304_1, 304_N, 812a, 812b, 812c) based on an I/O data mapping defined by a tag server (914) of the EDEI (912); and
storing the data on cloud storage (512, 808, 916).

10. The method of claim 9, further comprising communicatively connecting the virtualized industrial controller (810) to the industrial data stored on the cloud storage (512, 808, 916) via the EDEI (912).

11. The method of claim 9, wherein the collecting comprises collecting the industrial data from the one or more industrial devices (308_1, 310_2, 308_N, 310_1, 310_2, 310_N) via at least one cloud agent device (306_1, 306_N, 540, 814a, 814b, 814c) residing at the one or more industrial facilities (304_1, 304_N, 812a, 812b, 812c).

12. The method of claim 8, wherein the control program (804), executed by the virtualized industrial controller (810), monitors, via the EDEI (912), simulated input data from the simulation (806, 1014) and sends, via the EDEI, simulated output data to the simulation to perform monitoring and control of the simulation, and sending, as the output data, a recommendation for modifying the industrial system based on analysis of a behavior of the simulation in response to the monitoring and control performed by the virtualized industrial controller.

13. The method of claim 11, further comprising:
analyzing operation of the one or more industrial controllers (816a, 816b, 816c) based on one or more operational constraints defined by the control program (804); and
generating recommendation data specifying a recommended modification to one or more processes being controlled by the one or more industrial controllers based on a result of the analyzing.

14. A non-transitory computer-readable medium having stored thereon instructions that, in response to execution, cause a system (402) comprising a processor (416) to perform operations, the operations comprising:
executing a virtualized industrial controller (810) on a cloud platform (302, 502, 802), wherein the virtualized industrial controller executes a control program (804) that monitors operation of one or more industrial controllers (816a, 816b, 816c), wherein the control program defines at least one operational constraint to be applied to the one or more industrial controllers;
executing a simulation (806, 1014) of an industrial system on the cloud platform;
executing an emulation data exchange interface, EDEI (912), that facilitates exchange of simulation data between the virtualized industrial controller and the simulation;
performing analytics on a simulation session performed by the virtualized industrial controller and the simulation;
sending, by the system, output data to a client device via the cloud platform based on the analytics; and
sending a command output to at least one industrial controller of the one or more industrial controllers based on analysis of the operation of the one or more industrial controllers and the operational constraint.

15. The non-transitory computer-readable medium of claim 14, wherein the output data comprises a recommendation for modifying the industrial system based on analysis of the simulation (806, 1014) in response to monitoring and control by the virtualized industrial controller (810).

## Patentansprüche

1. System (402) zum Durchführen von industrieller Analytik, umfassend:
einen Speicher (418), der dazu konfiguriert ist, computerausführbare Komponenten zu speichern; und
einen Prozessor (416), der betriebsfähig mit dem Speicher verbunden ist, der dazu konfiguriert ist, die computerausführbaren Komponenten auszuführen, wobei die computerausführbaren Komponenten umfassen:
eine Emulationskomponente (406, 910, 1004), die dazu konfiguriert ist, eine virtualisierte Industriesteuerung (810) auf einer Cloud-Plattform (302, 502, 802) auszuführen, wobei die virtualisierte Industriesteuerung dazu konfiguriert ist, ein Steuerprogramm (804) zum Überwachen des Betriebs von einer oder mehreren Industriesteuerungen (816a, 816b, 816c) auszuführen, wobei das Steuerprogramm mindestens eine operationelle Beschränkung definiert, die auf die einen oder mehreren Industriesteuerungen anzuwenden ist;
eine Simulationskomponente (410, 1006), die dazu konfiguriert ist, eine Simulation (806, 1014) eines Industriesystems auf der Cloud-Plattform auszuführen;
eine Emulationsdaten-Austauschkomponente (408), die dazu konfiguriert ist, eine Emulationsdaten-Austauschschnittstelle (Emulation Data Exchange Interface, EDEI) (912) auszuführen, um die virtualisierte Industriesteuerung (810, 918, 1012) und die Simulation kommunikationsfähig miteinander zu verbinden; und
eine Analytikkomponente (412; 518), die zu Folgendem konfiguriert ist:
Erzeugen von Ausgabedaten, die an eine Client-Vorrichtung (520, 1010) gerichtet sind, über die Cloud-Plattform, basierend auf einer Analyse einer Simulationssitzung, die durch die Simulation und die virtualisierte Industriesteuerung durchgeführt wird, und
Senden einer Befehlsausgabe an mindestens eine Industriesteuerung der einen oder mehreren Industriesteuerungen basierend auf einer Analyse der Operation der einen oder mehreren Industriesteuerungen und der operationellen Beschränkung.

2. System nach Anspruch 1, wobei die EDEI (912) einen Tag-Server (914) umfasst, der zum Definieren von Datenelementen konfiguriert ist, die von den einen oder mehreren industriellen Vorrichtungen (308, 310) erfasst und auf einem Cloud-Speicher (512, 808, 916) gespeichert werden sollen, und wobei die EDEI des Weiteren dazu konfiguriert ist, die virtualisierte Industriesteuerung (810) und den Cloud-Speicher kommunikationsfähig miteinander zu verbinden.

3. System nach Anspruch 2, wobei die EDEI (912) des Weiteren dazu konfiguriert ist, mindestens einen Teilsatz der Datenelemente von den einen oder mehreren Industriesteuerungen (816a, 816b, 816c) über eine Cloud-Agentenvorrichtung (306_1, 306_N, 540, 814a, 814b, 814c) zu erfassen, die sich jeweils auf einen oder mehreren Werksanlagen (304_1, 304_N, 812a, 812b, 812c) befindet.

4. System nach Anspruch 1, wobei das Steuerprogramm (804), das von der virtualisierten Industriesteuerung (810) ausgeführt wird, dazu konfiguriert ist, über die EDEI (912) simulierte Eingabedaten von der Simulation zu überwachen und über die EDEI simulierte Ausgabedaten an die Simulation (806) zu senden, um die Überwachung und Steuerung der Simulation zu ermöglichen, und wobei die Ausgabedaten eine Empfehlung zur Modifizierung des industriellen Systems basierend auf einer Analyse der Simulation in Reaktion auf die Überwachung und Steuerung durch die virtualisierte Industriesteuerung umfasst.

5. System nach Anspruch 3, wobei das Steuerprogramm (804), das durch die virtualisierte Industriesteuerung (810) ausgeführt wird, dazu konfiguriert ist, die Operation der einen oder mehreren Industriesteuerungen (816a, 816b, 816c) basierend zumindest zum Teil auf dem Teilsatz der Datenelemente zu überwachen, wobei die virtualisierte Industriesteuerung zumindest den Teilsatz der Datenelemente über die EDEI (912) liest.

6. System nach Anspruch 5, wobei die Analytikkomponente (412, 518) des Weiteren dazu konfiguriert ist, Empfehlungsdaten zu erzeugen, die eine Empfehlung zum Ändern von einem oder mehreren Prozessen anzeigt, die von den einen oder mehreren Industriesteuerungen (816a, 816b, 816c) gesteuert werden, basierend auf einer Analyse der Operation der einen oder mehreren Industriesteuerungen.

7. System nach Anspruch 5, wobei die Befehlsausgabe mindestens eines aus einem Befehl zum Ändern eines Sollwertes, einem Befehl zum Ausführen einer anderen Steuerroutine auf der mindestens einen Industriesteuerung oder einem Befehl zum Ändern einer Steuersequenz umfasst, die durch die mindestens eine Industriesteuerung durchgeführt wird.

8. Verfahren zum Analysieren der Leistung eines Industriesystems, umfassend:
Ausführen, durch ein System (402), das mindestens einen Prozessor (416) umfasst, einer virtualisierten Industriesteuerung (810) auf einer Cloud-Plattform (302, 502, 802), wobei die virtualisierte Industriesteuerung ein Steuerprogramm (804) zum Überwachen der Operation von einer oder mehreren Industriesteuerungen (816a, 816b, 816c) ausführt, wobei das Steuerprogramm mindestens eine operationelle Beschränkung definiert, die auf die einen oder mehreren Industriesteuerungen angewendet werden soll;
Ausführen, durch das System, einer Simulation (806, 1014) eines industriellen Systems auf der Cloud-Plattform;
Ausführen, durch das System, einer Emulationsdaten-Austauschschnittstelle (Emulation Data Exchange Interface, EDEI) (912), die den Austausch von Simulationsdaten zwischen der virtualisierten Industriesteuerung und der Simulation ermöglicht;
Durchführen, durch das System, von Analytik an einer Simulationssitzung, die durch die virtualisierte Industriesteuerung und die Simulation durchgeführt wird;
Senden, durch das System, von Ausgabedaten an eine Client-Vorrichtung über die Cloud-Plattform, basierend auf der Analytik; und
Senden einer Befehlsausgabe an mindestens eine Industriesteuerung der einen oder mehreren Industriesteuerungen basierend auf einer Analyse der Operation der einen oder mehreren Industriesteuerungen und der operationellen Beschränkung.

9. Verfahren nach Anspruch 8, des Weiteren umfassend:
Erfassen von Industriedaten von einer oder mehreren industriellen Vorrichtungen (308_1, 310_2, 308_N, 310_1, 310_2, 310_N), die sich auf einen oder mehreren Industrieanlagen (304_1, 304_N, 812a, 812b, 812c) befinden, basierend auf einer I/O-Datenzuordnung, die durch einen Tag-Server (914) der EDEI (912) definiert wird; und
Speichern der Daten auf einem Cloud-Speicher (512, 808, 916).

10. Verfahren nach Anspruch 9, des Weiteren umfassend das kommunikationsfähige Verbinden der virtualisierten Industriesteuerung (810) mit den Industriedaten, die auf dem Cloud-Speicher (512, 808, 916) gespeichert sind, über die EDEI (912).

11. Verfahren nach Anspruch 9, wobei das Erfassen das Erfassen der Industriedaten von den einen oder mehreren industriellen Vorrichtungen (308_1, 310_2, 308_N, 310_1, 310_2, 310_N) über mindestens eine Cloud-Agentenvorrichtung (306_1, 306_N, 540, 814a, 814b, 814c) umfasst, die sich auf den einen oder mehreren Industrieanlagen (304_1, 304_N, 812a, 812b, 812c) befindet.

12. Verfahren nach Anspruch 8, wobei das Steuerprogramm (804), das von der virtualisierten Industriesteuerung (810) ausgeführt wird, über die EDEI (912) simulierte Eingabedaten von der Simulation (806, 1014) überwacht und über die EDEI simulierte Ausgabedaten an die Simulation sendet, um die Überwachung und Steuerung der Simulation durchzuführen, und Senden, als die Ausgabedaten, einer Empfehlung zur Modifizierung des industriellen Systems basierend auf einer Analyse eines Verhaltens der Simulation in Reaktion auf die Überwachung und Steuerung, die durch die virtualisierte Industriesteuerung durchgeführt wird.

13. Verfahren nach Anspruch 11, des Weiteren umfassend:
Analysieren der Operation der einen oder mehrere Industriesteuerungen (816a, 816b, 816c) basierend auf einen oder mehreren operationellen Beschränkungen, die von dem Steuerprogramm (804) definiert werden; und
Erzeugen von Empfehlungsdaten, die eine empfohlene Modifizierung für einen oder mehrere Prozesse angeben, die von den einen oder mehreren Industriesteuerungen gesteuert werden, basierend auf einem Ergebnis der Analyse.

14. Nicht transitorisches computerlesbares Medium, auf dem computerausführbare Befehle gespeichert sind, die in Reaktion auf die Ausführung ein System (402), umfassend einen Prozessor (416), zum Durchführen von Operationen veranlassen, wobei die Operationen umfassen:
Ausführen einer virtualisierten Industriesteuerung (810) auf einer Cloud-Plattform (302, 502, 802), wobei die virtualisierte Industriesteuerung ein Steuerprogramm (804) ausführt, das die Operation von einer oder mehreren Industriesteuerungen (816a, 816b, 816c) überwacht, wobei das Steuerprogramm mindestens eine operationelle Beschränkung definiert, die auf die einen oder mehreren Industriesteuerungen angewendet werden soll;
Ausführen einer Simulation (806, 1014) eines industriellen Systems auf der Cloud-Plattform;
Ausführen einer Emulationsdaten-Austauschschnittstelle (Emulation Data Exchange Interface, EDEI) (912), die den Austausch von Simulationsdaten zwischen der virtualisierten Industriesteuerung und der Simulation ermöglicht;
Durchführen von Analytik an einer Simulationssitzung, die durch die virtualisierte Industriesteuerung und die Simulation durchgeführt wird;
Senden, durch das System, von Ausgabedaten an eine Client-Vorrichtung über die Cloud-Plattform, basierend auf der Analytik; und
Senden einer Befehlsausgabe an mindestens eine Industriesteuerung der einen oder mehreren Industriesteuerungen basierend auf einer Analyse der Operation der einen oder mehreren Industriesteuerungen und der operationellen Beschränkung.

15. Nicht transitorisches computerlesbares Medium nach Anspruch 14, wobei die Ausgabedaten eine Empfehlung zum Modifizieren des industriellen Systems umfasst, basierend auf einer Analyse der Simulation (806, 1014) in Reaktion auf die Überwachung und Steuerung durch die virtualisierte Industriesteuerung (810).

## Revendications

1. Système (402) pour effectuer des analyses industrielles, comprenant:
une mémoire (418) configurée pour stocker des composants exécutables par ordinateur; et
un processeur (416), couplé de manière opérationnelle à la mémoire, qui est configurée pour exécuter les composants exécutables par ordinateur, les composants exécutables par ordinateur comprenant:
un composant d'émulation (406, 910, 1004) configuré pour exploiter un contrôleur industriel virtualisé (810) sur une plateforme en nuage (302, 502, 802), dans lequel le contrôleur industriel virtualisé est configuré pour exécuter un programme de contrôle (804) pour la surveillance du fonctionnement d'un ou plusieurs contrôleurs industriels (816a, 816b, 816c),
dans lequel le programme de contrôle définit au moins une contrainte opérationnelle à appliquer au ou aux contrôleurs industriels;
un composant de simulation (410, 1006) configuré pour exécuter une simulation (806, 1014) d'un système industriel sur la plate-forme en nuage;
un composant d'échange de données d'émulation (408) configuré pour exécuter une interface d'échange de données d'émulation, EDEI (912), pour la connexion en communication du contrôleur industriel virtualisé (810, 918, 1012) et la simulation; et
un composant d'analyse (412, 518) configuré pour:
générer des données de sortie dirigées vers un dispositif client (520, 1010) par l'intermédiaire de la plate-forme en nuage en fonction de l'analyse d'une session de simulation effectuée par la simulation et du contrôleur industriel virtualisé et
envoyer une sortie de commande à au moins un contrôleur industriel de l'un ou plusieurs contrôleurs industriels en fonction de l'analyse du fonctionnement du ou des contrôleurs industriels et de la contrainte opérationnelle.

2. Système selon la revendication 1, dans lequel l'EDEI (912) comprend un serveur d'étiquettes (914) configuré pour définir des éléments de données à collecter à partir d'un ou de plusieurs dispositifs industriels (308, 310) et stockés dans une mémorisation en nuage (512, 808, 916), et l'interface EDEI est en outre configurée pour connecter en communication le contrôleur industriel virtualisé (810) et la mémorisation en nuage.

3. Système selon la revendication 2, dans lequel l'interface EDEI (912) est en outre configurée pour collecter au moins un sous-ensemble des éléments de données provenant du ou des contrôleurs industriels (816a, 816b, 816c) par l'intermédiaire d'un dispositif d'agent en nuage (306_1, 306_N, 540, 814a, 814b, 814c) résidant sur un ou plusieurs équipements de l'installation (304_1, 304_N, 812a, 812b, 812C).

4. Système selon la revendication 1, dans lequel le programme de commande (804), exécuté par le contrôleur industriel virtualisé (810), est configuré pour surveiller, par l'intermédiaire de l'interface EDEI (912), des données d'entrée simulées à partir de la simulation et envoie, par l'intermédiaire de l'interface EDEI, des données de sortie simulées à la simulation (806) pour faciliter la surveillance et le contrôle de la simulation, et les données de sortie comprennent un recommandation pour modifier le système industriel en fonction de l'analyse de la simulation en réponse à la surveillance et au contrôle par le contrôleur industriel virtualisé.

5. Système selon la revendication 3, dans lequel le programme de commande (804), exécuté par le contrôleur industriel virtualisé (810), est configuré pour surveiller le fonctionnement de l'un ou de plusieurs contrôleurs industriels (816a, 816b, 816C) en fonction d'au moins le sous-ensemble des éléments de données, dans lequel le contrôleur industriel virtualisé lit au moins le sous-ensemble des éléments de données par l'intermédiaire de l'interface EDEI (912).

6. Système selon la revendication 5, dans lequel le composant d'analyse (412, 518) est en outre configuré pour générer des données de recommandation indiquant une recommandation pour modifier un ou plusieurs processus étant contrôlés par un ou plusieurs contrôleurs industriels (816a, 816b, 816c) en fonction de l'analyse du fonctionnement du ou des contrôleurs industriels.

7. Système selon la revendication 5, dans lequel la sortie de commande comprend au moins un élément parmi une commande pour modifier un point de consigne, une commande pour exécuter une routine de contrôle différente sur ledit au moins un contrôleur industriel ou une commande pour modifier une séquence de contrôle exécutée par ledit au moins un contrôleur industriel.

8. Procédé d'analyse des performances d'un système industriel, comprenant les étapes suivantes:
exécuter, par un système (402) comprenant au moins un processeur (416), d'un contrôleur industriel virtualisé (810) sur une plate-forme en nuage (302, 502, 802), dans lequel le contrôleur industriel virtualisé exécute un programme de commande (804) pour surveiller le fonctionnement d'un ou plusieurs contrôleurs industriels (816a, 816b, 816c), dans lequel le programme de contrôle définit au moins une contrainte opérationnelle à appliquer au ou aux contrôleurs industriels;
exécuter, par le système, une simulation (806, 1014) d'un système industriel sur la plate-forme en nuage;
exécuter, par le système, une interface d'échange de données d'émulation, EDEI (912), facilite l'échange de données de simulation entre le contrôleur industriel virtualisé et le simulation;
effectuer, par le système, des analyses sur une session de simulation réalisée par le contrôleur industriel virtualisé et la simulation;
envoyer, par le système, de données de sortie à un dispositif client par l'intermédiaire de la plate-forme en nuage en fonction des analyses; et envoyer une sortie de commande à au moins un contrôleur industriel du ou des industriels contrôleurs en fonction de l'analyse du fonctionnement du ou des contrôleurs industriels et de la contrainte opérationnelle.

9. Procédé selon la revendication 8, comprenant en outre:
la collecte de données industrielles d'un ou de plusieurs dispositifs industriels (308_1, 310_2, 308_N, 310_1, 310_2, 310_N) situés dans une ou plusieurs installations industrielles (304_1, 304_N, 812a, 812b, 812c) en fonction d'un mappage de données E/S défini par un serveur d'étiquettes (914) de l'interface EDEI (912); et le stockage des données sur la mémorisation en nuage (512, 808, 916).

10. Procédé selon la revendication 9, comprenant en outre la connexion en communication du contrôleur industriel virtualisé (810) aux données industrielles stockées sur la mémorisation en nuage (512, 808, 916) par l'intermédiaire de l'interface EDEI (912).

11. Procédé selon la revendication 9, dans lequel la collecte consiste à recueillir les données industrielles à partir du ou des dispositifs industriels (308_1, 310_2, 308_N, 310_1, 310_2, 310_N) par l'intermédiaire dudit au moins un dispositif d'agent en nuage (306_1, 306_N, 540, 814a, 814b, 814c) résidant dans la ou les installations industrielles (304_1, 304_N, 812a, 812b, 812c).

12. Procédé selon la revendication 8, dans lequel le programme de commande (804), exécuté par le virtualisé industriel le contrôleur (810) surveille, par l'intermédiaire de l'interface EDEI (912), des données d'entrée simulées du simulateur (806, 1014) et envoie, par l'intermédiaire de l'interface EDEI, des données de sortie simulées à la simulation pour effectuer la surveillance et le contrôle de la simulation et envoie, comme données de sortie, une recommandation de modification du système industriel en fonction de l'analyse d'un comportement de la simulation en réponse à la surveillance et au contrôle effectués par le contrôleur industriel virtualisé.

13. Procédé selon la revendication 11, comprenant en outre les étapes suivantes:
analyser le fonctionnement du ou des contrôleurs industriels (816a, 816b, 816c) en fonction d'une ou de plusieurs contraintes opérationnelles définies par le programme de commande (804); et
générer des données de recommandation spécifiant une modification recommandée à un ou plusieurs processus contrôlés par le ou les contrôleurs industriels en fonction d'un résultat de l'analyse.

14. Support lisible par ordinateur non transitoire sur lequel sont stockées des instructions, qui en réponse à l'exécution, conduisent un système (402) comprenant un processeur (416) à réaliser des opérations, les opérations comprenant les étapes suivantes:
exécuter un contrôleur industriel virtualisé (810) sur une plate-forme en nuage (302, 502, 802), dans lequel un contrôleur industriel virtualisé exécute un programme de contrôle (804) qui surveille le fonctionnement d'un ou plusieurs contrôleurs industriels (816a, 816b, 816c), dans lequel le programme de commande définissant au moins une contrainte opérationnelle à appliquer au ou aux contrôleurs industriels;
exécuter une simulation (806, 1014) d'un système industriel sur la plate-forme en nuage;
exécuter une interface d'échange de données d'émulation, EDEI (912) facilite l'échange de données de simulation entre le contrôleur industriel virtualisé et le simulation;
effectuer des analyses sur une session de simulation réalisée par le contrôleur industriel virtualisé et la simulation;
envoyer, par le système, de données de sortie à un dispositif client par l'intermédiaire de la plate-forme en nuage en fonction des analyses; et
envoyer une sortie de commande à au moins un contrôleur industriel du ou des industriels contrôleurs en fonction de l'analyse du fonctionnement du ou des contrôleurs industriels et de la contrainte opérationnelle.

15. Support lisible par ordinateur non transitoire selon la revendication 14, dans lequel les données de sortie comprennent une recommandation de modification du système industriel en fonction de l'analyse de la simulation (806, 1014) en réponse à la surveillance et au contrôle par le contrôleur industriel virtualisé (810).
